(19) Europäisches Patentamt
European Patent Office
Office européen des brevets

(11) EP 2 289 213 B1

(12) # EUROPÄISCHE PATENTSCHRIFT

(45) Veröffentlichungstag und Bekanntmachung des Hinweises auf die Patenterteilung:
**10.01.2018 Patentblatt 2018/02**

(21) Anmeldenummer: **09765648.2**

(22) Anmeldetag: **22.06.2009**

(51) Int Cl.:
***H04L 5/00*** *(2006.01)*
***H04L 1/00*** *(2006.01)*
***H04L 27/34*** *(2006.01)*
***H04L 27/18*** *(2006.01)*
*H04L 25/02 (2006.01)*
*H04L 29/06 (2006.01)*
***H03M 13/35*** *(2006.01)*
***H04L 27/26*** *(2006.01)*
***H04N 19/33*** *(2014.01)*
*H04L 1/06 (2006.01)*
*H04L 25/03 (2006.01)*

(86) Internationale Anmeldenummer:
**PCT/EP2009/004488**

(87) Internationale Veröffentlichungsnummer:
**WO 2009/153068 (23.12.2009 Gazette 2009/52)**

(54) **VORRICHTUNG ZUM ZUWEISEN UND SCHÄTZEN VON ÜBERTRAGUNGSSYMBOLEN**

APPARATUS FOR ASSIGNING AND ASSESSING TRANSMISSION SYMBOLS

DISPOSITIF D'ATTRIBUTION ET D'ÉVALUATION DE SYMBOLES DE TRANSMISSION

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **20.06.2008 DE 102008029353**

(43) Veröffentlichungstag der Anmeldung:
**02.03.2011 Patentblatt 2011/09**

(73) Patentinhaber: **Fraunhofer-Gesellschaft zur Förderung der angewandten Forschung e.V.
80686 München (DE)**

(72) Erfinder:
- **JAECKEL, Stephan
10785 Berlin (DE)**
- **JUNGNICKEL, Volker
10318 Berlin (DE)**
- **SCHIERL, Thomas
10437 Berlin (DE)**
- **HELLGE, Kornelius
10437 Berlin (DE)**
- **HAUSTEIN, Thomas
14469 Potsdam (DE)**

(74) Vertreter: **Schenk, Markus et al
Schoppe, Zimmermann, Stöckeler
Zinkler, Schenk & Partner mbB
Patentanwälte
Radlkoferstrasse 2
81373 München (DE)**

(56) Entgegenhaltungen:
**EP-A1- 1 895 732**
**EP-A1- 1 928 115**
**US-A1- 2006 013 168**
**US-A1- 2007 165 705**

- **YIYAN WU ET AL: "Comparison of Terrestrial DTV Transmission Systems: The ATSC 8-VSB,the DVB-T COFDM, and the ISDB-T BST-OFDM" IEEE TRANSACTIONS ON BROADCASTING, Bd. 46, Nr. 2, 1. Juni 2000 (2000-06-01), XP011006128 IEEE SERVICE CENTER, PISCATAWAY, NJ, US ISSN: 0018-9316**
- **MURALI R CHARI ET AL: "FLO Physical Layer: An Overview" IEEE TRANSACTIONS ON BROADCASTING, Bd. 53, Nr. 1, 1. März 2007 (2007-03-01), Seiten 145-160, XP011172013 IEEE SERVICE CENTER, PISCATAWAY, NJ, US ISSN: 0018-9316 DOI: 10.1109/TBC.2007.891696**
- **DEB S ET AL: "Real-Time Video Multicast in WiMAX Networks" IEEE CONFERENCE ON COMPUTER COMMUNICATIONS, 13. April 2008 (2008-04-13), Seiten 1579-1587, XP031263968 IEEE, PISCATAWAY, NJ, USA ISBN: 978-1-4244-2025-4**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

(Forts. nächste Seite)

- **VOLKER JUNGNICKEL ET AL: "SC-FDMA Waveform Design, Performance, Power Dynamics and Evolution to MIMO", 1 May 2007 (2007-05-01), PORTABLE INFORMATION DEVICES, 2007. PORTABLE07. IEEE INTERNATIONAL CON FERENCE ON, IEEE, PI, PAGE(S) 1 - 6, XP031094640, ISBN: 978-1-4244-1039-2**

**Beschreibung**

Die vorliegende Erfindung bezieht sich auf die Übertragung von Datenströmen, die sich aus Teilströmen unterschiedlicher Signifikanz zusammensetzen, wie es beispielsweise bei einem skalierbaren Videokodec der Fall ist.

Typischerweise hängen in Funknetzwerken, beispielsweise in Mobilfunknetzwerken, Übertragungsfehler von der Empfangsqualität ab. Mehrere Konzepte sind im Bereich der konventionellen Technik bereits bekannt, die beispielsweise durch Ausnutzen von Diversität die Fehleranfälligkeit von Datenübertragungen verbessern. Beispielsweise versuchen derzeitige Funkübertragungssysteme, wie z.B. UMTS (UMTS = Universal Mobile Telecommunication Systems), HSPA (HSPA = High Speed Paket Access), LTE (LTE = Long Term Evolution), usw., die zur Verfügung stehenden Übertragungsbandbreite möglichst gut auszunutzen, indem die Datenübertragungsrate eines Nutzers an die Kanalqualität angepasst wird. Dazu sind Schleifen notwendig, d.h. ein Nutzer vermisst den Kanal, und berichtet dem Netz, d.h. einer Basisstation oder Node B, über den Kanalzustand, sogenanntes CSI (CSI = Channel State Information).

Modernere Übertragungstechniken, wie z.B. das Ausnutzen mehrerer Sende- oder Empfangsantennen, sogenanntes MIMO (MIMO = Multiple Input Multiple Output), Raum-Zeit-Multiplex, sogenannte Space Time Codes (STC = Space Time Codes) oder Spreiztechniken, werden benutzt, um Übertragungsraten zu erhöhen, bzw. die Abdeckung zu vergrößern oder zuverlässiger zu machen.

Im Bereich der Multimediaapplikationen, wird die Übertragung von Audio- und Videodaten zunehmend bedeutender, beispielsweise werden Codierverfahren ständig weiterentwickelt. Im Bereich der Videocodierung sind Konzepte der skalierbaren Videocodierung, vgl. AVC (AVC = Advanced Video Coding) und SVC (SVC = Scalable Video Codec), bekannt, die ebenfalls bestrebt sind, eine zu Verfügung stehende Datenrate möglichst gut auszunutzen.

Die Videoübertragung in Mobilfunknetzen stellt ein Problem dar. Da es sich bei Videoausstrahlung, wie beispielsweise Fernsehprogrammen, um Rundfunkdaten handelt, stehen keine individuellen Rückmeldungen der Teilnehmer zur Verfügung. In anderen Worten richtet sich eine Rundfunkübertragung an eine Vielzahl von Nutzern, die es nicht erlaubt, von jedem Nutzer individuelle Rückmeldung über eine Übertragungsqualität zu erhalten. Konventionelle Konzepte, die eine breitbandige drahtlose Videoübertragung in zellularen Mobilfunkarchitekturen bei geringer Sendeleistung sowohl mit hoher Reichweite als auch mit hoher Ausfallsicherheit ermöglichen, können im Rundfunkfall mangels Rückmeldung der einzelnen Teilnehmer nicht verwendet werden.

Der frequenzselektive Mehrwegekanal stellt hohe Anforderungen an die Übertragungsverfahren. Neue Techniken wie beispielsweise MIMO, frequenzselektives Scheduling sowie Raum-Zeit-Codierung benötigen oftmals Rückmeldungen oder Feedback über die Kanalgüte am Empfänger, um optimal eingesetzt werden zu können.

Konventionelle Rundfunkkonzepte verwenden beispielsweise DVB (DVB = Digital Video Broadcast), speziell beispielsweise bei dem terrestrischen Fernsehen DVB-T (T = Terrestrial). Beispielsweise werden bei diesem Konzept einige exponierte Standorte als Basisstationen verwendet, und ein mittels MPEG-2 (MPEG-2 = Moving Pictures Expert Group 2) codiertes Videosignal über ein Mehrträgerverfahren, wie beispielsweise OFDM (OFDM = Orthogonal Frequency Division Multiplexing) abgestrahlt. Der breitbandige Funkkanal unterliegt jedoch den für den Mobilfunk üblichen Ausbreitungsbedingungen. Durch die Mehrwegeausbreitung können sich Teile des Signals durch destruktive Überlagerung auslöschen, und sogenannten schnellen Schwund (der auch Fast Fading genannt wird) hervorrufen. Die dadurch entstehenden Übertragungs- oder Bitfehler am Empfänger können durch Hinzufügen von Redundanz, d.h. im Rahmen einer Kanalcodierung, wieder korrigiert werden, jedoch zum Preis von reduzierten Übertragungsraten.

Abschattungen der direkten Sichtverbindung, die auch langsamer Schwund oder Slow Fading genannt werden, können auch in kleinen Regionen, größenordnungsmäßig wenige Meter, zu erheblichen Einbrüchen der Empfangsleistung führen. Um dem entgegenzuwirken, wird zum Teil mit hohen Sendeleistungen, bei DVB-T beispielsweise mehr als 100 kW bei 5 MHz Bandbreite, gearbeitet. Trotzdem kann von "mobilem Fernsehen" nur in der Nähe, d.h. bis auf wenige Kilometer Entfernung, von der Basisstation gesprochen werden. Sollen größere Distanzen überwunden werden, so sind zumeist speziell auf den Sender ausgerichtete Antennen notwendig.

Die US 2006/0013168 A1 beschreibt Techniken zum Senden von Daten von einem drahtlosen Kommunikationssystem. Physikalische Kanäle, die in einem Überrahmen zu senden sind, werden identifiziert und Zeitschlitzen in dem Überrahmen zugeordnet. Die Codierung und Modulation für jeden physikalischen Kanal wird basierend auf seiner Kapazität ausgewählt. Die Daten für jeden physikalischen Kanal werden selektiv codiert basierend auf einer äußeren Coderate, z.B. für einen Reed-Solomon Code, und ferner codiert basierend auf einer inneren Coderate, z.B. für einen Turbo-Code. Die codierten Daten für jeden physikalischen Kanal werden auf Modulationssymbole abgebildet, basierend auf einem ausgewählten Modulationsschema. Die Modulationssymbole für jeden physikalischen Kanal werden ferner verarbeitet (z.B. OFDM-moduliert) und multigeplext auf die Zeitschlitze, die dem physikalischen Kanal zugeordnet sind. Daten, die unter Verwendung anderer Funktechnologie (z.B. W-CDMA) zu senden sind, werden auch verarbeitet und multipliziert auf Zeitschlitze, die für diese Funktechnologie zugeordnet sind.

Das Dokument "FLO-Physical layer: An Overview", IEEE TRANSACTIONS ON BROADCASTING, Bd. 53, Nr. 1, 1. März 2007, Seiten 145-160, IEEE SERVICE CENTER, PISCATAWAY, NJ, US, ISSN: 0018-9316, gibt eine Übersicht über die physikalische Schicht der Forward Link Only- (FLO-) Luftschnittstelle. Die FLO-Luftschnittstelle ist eine Schlüsselkomponente des MediaFLO-Systems, entwickelt durch QUALCOMM als eine alternative mobile Multicasttechnologie für die effiziente Übertragung mehrerer Multimediaströme an mobile Geräte unter Verwendung von TV- und Multimediasignalbandbreiten in VHF, UHF oder L-Band. Die Hauptkonzepte und Merkmale der FLO-Luftschnittstelle einschließlich der verwendeten Modulations- und Codiertechniken, der Rahmenstruktur und der unterschiedlichen Unterkanäle in der physikalischen Schicht werden beschrieben. Die verfügbaren Datenraten sowie andere Charakteristika von FLO werden ebenfalls beschrieben. Schließlich wird die Leistungsfähigkeit der FLO-physikalischen Schicht in beispielhaften Kanalumgebungen dargestellt.

"Real-Time Video Multicast in WiMAX Networks", IEEE CONFERENCE ON COMPUTER COMMUNICATIONS, 13. April 2008, Seiten 1579-1587, IEEE, PISCATAWAY, NJ, USA, ISBN: 978-1-4244-2025-4, IEEE 802.16e WiMAX ist eine vielversprechende neue Technologie für Breitbandzugriffsnetzwerke. Unter der Klasse von Anwendungen, die unterstützt werden können, sind Echtzeitvideodienste (wie z.B. IPTV, Rundsenden von Live-Ereignissen usw.). Diese Anwendungen sind bandbreitenintensiv und haben strenge Verzögerungsbeschränkungen. Somit ist eine skalierbare Unterstützung für solche Anwendungen ein herausforderndes Problem. Um dieses Problem zu adressieren, wird eine Kombination aus Lösungsansätzen betrachtet, die Multicast, schichtcodiertes Video und adaptive Modulation von Übertragungen verwenden. Unter Verwendung derselben werden Algorithmen entwickelt, um effiziente, faire und zeitgemäße Lieferung von Video in WiMAX-Netzwerken sicherzustellen. Das entsprechende Ressourcenzuordnungsproblem ist herausfordernd, da Zeitplanentscheidungen (in einer WiMAX-Basisstation) in Echtzeit durchgeführt werden über zwei Dimensionen, Zeit und Frequenz. Darüber hinaus ruft das Kombinieren von geschichtetem Video mit geeigneten Modulationen nach neuartigen MAC-Algorithmen. Das Multicast-Ressourcenzuordnungsproblem in WiMAX wird modelliert und es wird gezeigt, dass dieses Problem NP-beständig ist. Ein schneller gieriger Algorithmus wird dargelegt der (i) wahrscheinlich innerhalb einer konstanten Näherung der optimalen Lösung liegt (basierend auf einer Messung, die Videoqualität reflektiert, wie sie durch den Nutzer wahrgenommen wird), und (ii) 87-95° des Optimums darstellt, wie es durch realistische Simulationen gezeigt wird. Es wird aufgezeigt, dass dieser Algorithmus eine 25%ige Verbesserung bietet im Vergleich zu einem naiven Algorithmus. Darüber hinaus, bezüglich der durchschnittlichen durch jeden Nutzer empfangenen Rate überschreitet dieser Algorithmus den naiven Algorithmus um mehr als 50%.

Die EP 1 928 115 A1 beschreibt ein Verfahren und ein System zum Senden von Daten durch einen Sender über einen Kanal mit einer vorbestimmten Kanalqualitätsschätzung, das folgende Schritte aufweist: Teilen von Eingangsdatenströmen, die zu übertragen sind, in eine Mehrzahl von Datenteilströmen; Verarbeiten jedes der Mehrzahl von Datenteilströmen in eine Mehrzahl von Symbolteilsätzen durch Auswählen eines bestimmten Schemas codierter Modulation (BPSK, QPSK, 16-QAM); getrenntes Verarbeiten jedes der Mehrzahl von Symbolteilsätzen über eine Mehrzahl von getrennten diskreten Fourier-Transformationen, hierin nachfolgend als DFTs bezeichnet, um eine Mehrzahl von DFT-vorcodierten Datenteilströmen zu erhalten; Zuordnen jedes DFT-vorcodierten Datenteilstroms in einen Frequenzressourcenblock über ein Teilträgerabbildungsmodul, so dass für jeden Datenteilstrom das ausgewählte Schema der codierten Modulation abhängig von den Werten der Kanalqualitätsschätzung an den Frequenzen seines eigenen zugeordneten Frequenzressourcenblocks gewählt wird.

Die US 2007/0165705 A1 beschreibt Codemehrfachzugriff (CDMA), eine beliebte Mehrfachzugriffstechnik, die verwendet wird, um mehrere Nutzer gleichzeitig in einem Netzwerk zu unterstützen. Es gibt viele Variationen von CDMA, einschließlich Direkt-Sequenz (DS)-CDMA, Mehrträger(MC)-CDMA, zyklisch vorgefestigte (CP)-CDMA, und Chip verschachtelte Blockausbreitungs-(CIBS)-CDMA. Zusätzlich zu diesen Variationen sind viele Empfängerarchitekturen verfügbar für Implementierung in CDMA-Systemen, wie z.B. die gutbekannten RAKE-Empfänger, Störungsaufhebungsempfänger und Empfänger, die sich auf Kanalentzerrung verlassen. Viele MUI-freie Techniken verlassen sich auf Nutzertrennung in der Frequenzdomain durch Zuweisen gegenseitig ausschließlicher Sätze von Tönen zu jedem Nutzer. Die bekannten Techniken von Mehrfachzugriff ermöglichen es jedoch nicht jedem einzelnen Nutzer die Frequenzdiversität in dem Kanal voll auszunützen, da jeder Nutzer nur einen Teil der gesamten verfügbaren Bandbreite verwendet, um eine Mitteilung zu senden. Nutzer können die Frequenzdiversität verbessern und adaptiv ausnutzen in dem Kanal einfach durch Ändern der Ausbreitungscodes, die in einem Block-CDMA-System verwendet werden. MUI-freie Übertragung wird beibehalten durch Verwenden der hierin offenbarten Techniken. Ferner kann diese Technik ohne Weiteres ausgedehnt werden auf Mehrfacheingangs-Mehrfachausgangs(MIMO)-Systeme.

"SC-FDMA Waveform Design, Performance, Power Dynamics and Evolution to MIMO", 1. Mai 2007. IEEE INTERNATIONAL CONFERENCE ON PORTABLE INFORMATION DEVICES, IEEE, PI, PAGE(S) 1 - 6, ISBN: 978-1-4244-1039-2, untersucht Signalverlaufsentwurf, Leistungsfähigkeit und Leistungsdynamik der lokalisierten Form des Einzelträgerfrequenzteilungsmehrfachzugriffs (SC-FDMA), der berücksichtigt wird für eine Aufwärtsverbindung in der 3GPP-langfristigen Entwicklung (LTE). Ein klassisches Einzelträgerschema mit zur Wurzel erhobenem Cosinusfiltern und zwei DFTbasierte Schemata werden berücksichtigt, eines mit und ein anderes ohne neuartige spektrale Ausdehnung. Es wird gezeigt, wie das Entwerfen von Signalverläufen ähnlich zu dem klassischen Schema durch Verwenden dieser spektralen Ausdehnung verläuft. Die Vorteile sind, dass nun der Sender und der Empfänger voll in dem Frequenzbereich spezifiziert werden können und jeder Bruchteil der Gesamtbandbreite einem Nutzer zugeordnet werden kann. Für Konstantamplitudenmodulation (z.B. BPSK, QPSK) wird die Leistungsdynamik um 3 dB mit spektraler Ausdehnung reduziert. Dies wird selbstverständlich für 25% mehr Bandbreite erkauft. Die inhärente Leistungsdynamik komplexer QAM-Konstellationen deckt Teil dieser Verstärkung ab. Spektrale Ausdehnung kann manchmal ausgelassen werden, z.B. für 16-QAM in der 3 GPP-LTE-Aufwärtsverbindung. Die Entwicklung zu MIMO folgt direkt aus dem Empfängerkonzept basierend auf virtuellen Antennen.

Es ist die Aufgabe der vorliegenden Erfindung, ein verbessertes Konzept zur Übertragung von Mediadaten zu schaffen.

Diese Aufgabe wird gelöst durch die Gegensätze der unabhängigen Ansprüche

Der vorliegenden Erfindung liegt die Kenntnis zugrunde, dass Teilströme skalierbarer Codierungsverfahren unterschiedlich moduliert werden können. Die zur Verfügung stehenden Funkressourcen können so effizienter eingesetzt werden und an die Signifikanz der Teilströme angepasst werden. Beispielsweise kann in einem skalierbaren Videocodierungsverfahren wie beispielsweise H.264/SVC eine Adaption an die Quelle erfolgen. Beispielsweise können Ausführungsbeispiele mittels Spreizung, Raum-Zeit-Codierung und Adaption des Modulationsverfahrens an das Videosignal eine hohe Videobandbreite bei gleichzeitiger Ausfallsicherheit und hoher Reichweite erlauben. In Ausführungsbeispielen kann dafür beispielsweise vorhandene Mobilfunkinfrastruktur verwendet werden, die je nach Ausführungsbeispiel auch mit geringerer Sendeleistung betrieben werden kann.

In anderen Worten liegt der Kerngedanke der vorliegenden Erfindung darin, dass beispielsweise Konzepte, die aus Mobilfunksystemen bekannt sind und Konzepte, die beispielsweise aus der Videocodierung bekannt sind, derart kombiniert werden, dass adaptive, flexible und zuverlässige Rundfunkübertragung an eine Vielzahl von Nutzern ermöglicht wird.

Ausführungsbeispiele der vorliegenden Erfindung werden nun anhand der beiliegenden Figuren im Detail erläutert. Es zeigen:

Fig. 1 ein Ausführungsbeispiel des prinzipiellen Aufbaus einer skalierbaren Videocodierung;

Fig. 2 ein Ausführungsbeispiel zur Illustration eines Gleichfrequenznetzwerkes;

Fig. 3 ein Ausführungsbeispiel zur Illustration von Raum-Zeit-Codierung;

Fig. 4 ein Ausführungsbeispiel eines zellularen Netzwerks mit Raum-Zeit-Codierung;

Fig. 5 ein Ausführungsbeispiel einer Signalverarbeitungskette;

Fig. 6 Simulationsergebnisse basierend auf einem Ausführungsbeispiel;

Fig. 7 weitere Simulationsergebnisse basierend auf einem Ausführungsbeispiel;

Fig. 8 ein Ausführungsbeispiel einer Anordnung von Basisstationen;

Fig. 9 Simulationsergebnisse mit verschiedenen Ausführungsbeispielen;

Fig. 10 ein Blockschaltbild einer Signalverarbeitungskette in einem Ausführungsbeispiel eines Übertragungssystems; und

Fig. 11 für die Erläuterung der Ausführungsbeispiele relevante Gleichungen.

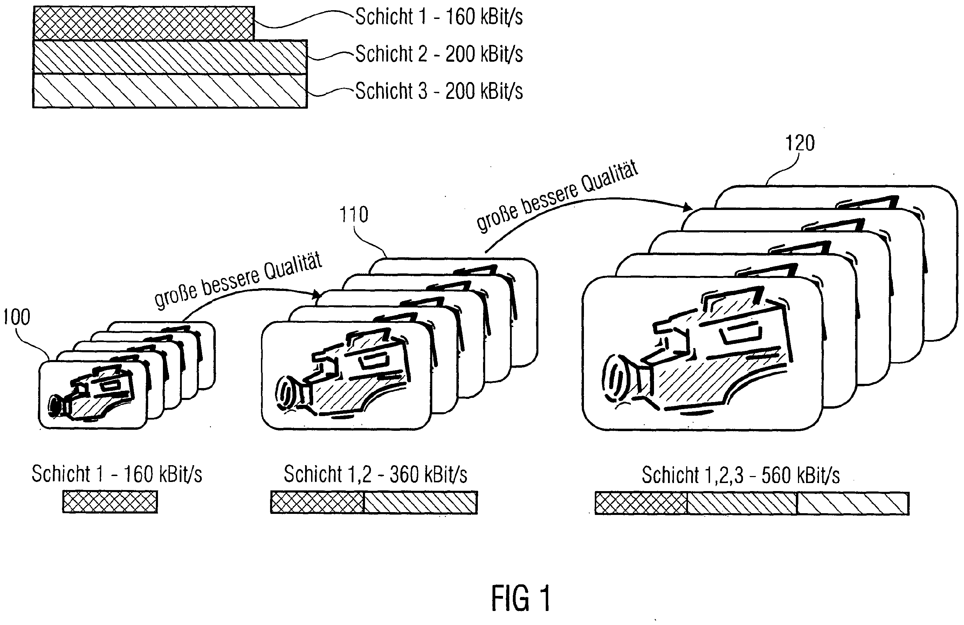

SVC ist eine Erweiterung des H.264/AVC Videokomprimierungsstandards, vgl. ITU-T Recommendation H.264 and ISO/IEC 14496-10 (MPEG-4 AVC), Advanced video coding for generic audiovisual services - Version 8 (including SVC extension), ITU-T and ISO/IEC JTC 1, 07 2007). SVC erlaubt effiziente Skalierung zeitlicher, räumlicher und Qualitätsauflösung in einem Videosignal. Skalierbarkeit wird dann erreicht, wenn Teile des Datenstromes verloren gehen können, wobei das restliche Signal dennoch eine Dekodierung des Videosignals erlaubt. Dies wird beispielhaft in dem Ausführungsbeispiel einer skalierbaren Videocodierung gezeigt, welches in der Fig. 1 dargestellt ist. In dem Ausführungsbeispiel der Fig. 1 wird von einer skalierbaren Videocodierung ausgegangen, die in drei Schichten, sogenannte Layer, erfolgt. Die einzelnen Schichten entsprechen dabei Teildatenströmen von Mediadaten, von denen die Schicht 1 die Dekodierung eines Videosignals in einer Basisqualität erlaubt.

Sind zusätzlich zu den Daten der Schicht 1 auch die Daten der Schicht 2 verfügbar, so lässt sich ein Videosignal dekodieren, dessen Auflösung oder Qualität gegenüber dem ersten Videosignal verbessert ist. In analoger Weise lässt sich ein gegenüber dem zweiten Videosignal verbessertes drittes Videosignal erzeugen, wenn die Daten aller drei Teilströme zur Verfügung stehen. In dem Ausführungsbeispiel der Fig. 1 wird beispielhaft davon ausgegangen, dass der Teildatenstrom der Schicht 1 eine Datenrate von 160 kBit/s aufweist, der Datenstrom der Schicht 2 eine Datenrate von 200 kBit/s aufweist und der Datenstrom der Schicht 3 Daten ebenfalls einer Datenrate von 200 kBit/s aufweist. Es sei darauf hingewiesen, dass die Schicht 1 Daten, d.h. der Teilstrom der Schicht 1, am wichtigsten ist. Werden an einem Empfänger nur Schicht 1 Daten empfangen, so ist die Dekodierung eines Videosignals möglich. Die Daten der Schicht 2 und Schicht 3, ermöglichen dieses Videosignal zu verbessern, beispielsweise hinsichtlich seiner Auflösung, d.h. ein größeres Bild zu erzeugen, oder auch hinsichtlich seiner Qualität, d.h. beispielsweise eine höhere Farbtiefe oder eine höhere Auflösung zu erzeugen.

Die Fig. 1 veranschaulicht dies anhand eines ersten Satzes von Bildern 100, die mit den Daten der Schicht 1 erzeugbar sind und die beispielsweise eine Datenrate von 160 kBit/s aufweisen. Die Fig. 1 zeigt ferner die etwas größeren Bilder 110, die mit den Daten der Schichten 1 und 2 erzeugbar sind, d.h. mit insgesamt 360 kBit/s. In der Fig. 1 ist ferner angedeutet, dass die Bilder, die aufgrund der Daten der Schichten 1 und 2 erzeugbar sind gegenüber den Bildern, die lediglich basierend auf den Daten der Schicht 1 erzeugbar sind, größer oder mit verbesserter Qualität vorliegen. In analoger Weise zeigt die Fig. 1 einen Satz von Bildern 120, die mit den Daten der Schichten 1, 2 und 3 erzeugbar sind, d.h., die auf einer Datenrate von 560 kBit/s basieren. Im Vergleich zu dem Satz von Bildern 110 ist der Satz von Bildern 120 wiederum hinsichtlich oder Größe der Auflösung des Einzelbildes, bzw. in der Qualität der Bilder verbessert.

Durch den Einsatz einer skalierbaren Videocodierung, wie z.B. H.264/SVC kann ein Mediadatenstrom in verschiedene Teilströme unterteilt werden. Diese Schichten oder Layer können nun zu verschiedenen Qualitätsstufen kombiniert werden. Fällt beispielsweise der höchste Layer aus, am Beispiel der Fig. 1 wäre das die Schicht 3, können die unteren Ströme, also die Schicht 1 und die Schicht 2, zu einem Video mit reduzierter Qualität kombiniert werden.

Die verschiedenen Layer oder Schichten eines SVC-Stromes, d.h. Mediastromes, können nun mit unterschiedlichen Modulationsmechanismen ausgestattet werden, so dass je nach Kanalgüte unterschiedliche Teile des Signals dekodiert werden können. In anderen Worten können die wichtigeren Schichten, am Beispiel der Fig. 1 entspricht dies der Schicht 1, mit einem Modulationsalphabet übertragen werden, dass robuster ist, als ein Modulationsalphabet, das für eine höhere Schicht verwendet wird.

Ausführungsbeispiele der vorliegenden Erfindung umfassen daher Vorrichtungen zum Zuweisen von Übertragungssymbolen zu einem Mediadatenstrom von Informationssymbolen, wobei der Mediadatenstrom einen ersten Teilstrom zur Darstellung der Mediadaten in einer Basisqualität umfasst und der Datenstrom einen zweiten Teilstrom mit Zusatzdaten zur Darstellung der Mediadaten zusammen mit dem ersten Teilstrom in einer verbesserten Qualität umfasst. Die Vorrichtung zum Zuweisen umfasst dabei eine erste Einrichtung zum Zuweisen erster Übertragungssymbole zu den Informationssymbolen des ersten Teilstromes und eine zweite Einrichtung zum Zuweisen zweiter Übertragungssymbole zu den Informationssymbolen des zweiten Teilstromes, wobei die ersten Übertragungssymbole gegenüber den zweiten Übertragungssymbolen über einen Übertragungskanal mit geringerer Fehlerwahrscheinlichkeit übertragbar sind.

Ausführungsbeispiele sind dabei nicht auf zwei Teilströme beschränkt, sondern können allgemein beliebig viele, oder N, Teilströme aufweisen, wobei beispielsweise zwei Teilströme die oben genannten Eigenschaften erfüllen. Im folgenden werden mehrere Ausführungsbeispiele betrachtet, im Detail wird ein Ausführungsbeispiel mit drei Teilströmen am Beispiel einer skalierten Videokodierung betrachtet.

Die Mediadaten können dabei skalierbare Videodaten, aber auch skalierbare Audiodaten umfassen. Bezüglich Audiodaten wäre es beispielsweise denkbar, dass ein Monosignal mit einem robusten Modulationsalphabet übertragen wird, wohingegen Zusatzinformationen, die eine Stereodekodierung oder eine räumliche Audiodekodierung erlauben, mit einem entsprechend zusätzlichen Modulationsalphabet übertragen werden. Generell sind hierbei alle erdenklichen Mediadaten verwendbar. Beispielsweise könnten auch Fotos, anhand eines ersten Modulationsalphabetes in einer Basisqualität encodiert werden, und Zusatzinformationen zur Dekodierung in einer verbesserten Qualität in einem fehleranfälligeren Modulationsalphabet.

In Ausführungsbeispielen können auch entsprechende Fehlerschutzmechanismen, wie z.B. verschiedene Kanalcodierungskonzepte für die Informationssymbole bzw. Übertragungssymbole der Teilströme zum Einsatz kommen.

Dies Skalierbarkeit von Mediadaten gewinnt gerade in Bezug auf Funknetzwerke und Mobilfunknetzwerke zunehmend an Bedeutung. Ausführungsbeispiele erlauben den Mediainhalt einmalig zu encodieren, wobei dabei die höchste Auflösung oder Bitrate verwendet werden kann. Versionen der Mediainhalte mit geringerer Qualität können dann durch teilweises Dekodieren erhalten werden. Dies ist insbesondere vorteilhaft für mobile Empfänger, deren Ressourcen beschränkt sind, beispielsweise weisen Mobilteile oftmals begrenzte Rechenleistung, Energieversorgung, Auflösung eines Bildschirmes, usw. auf. In Ausführungsbeispielen kann die Skalierbarkeit der Medieninhalte weiter gefördert werden, indem die einzelnen Teilströme mit unterschiedlicher Codierung versehen werden, d.h. einzelnen Teilströmen kann in Ausführungsbeispielen unterschiedliche Redundanz hinzugefügt werden. Ferner ist es in Ausführungsbeispielen denkbar, dass in einzelnen Teilströmen unterschiedliche Leistungen zugeordnet werden, so dass eine Raten- oder Qualitätsanpassung nicht nur am Sender, sondern auch am Empfänger ermöglicht wird.

In einem Ausführungsbeispiel kann die erste Einrichtung zum Zuweisen der ersten Übertragungssymbole zu den Informationssymbolen des ersten Teilstromes angepasst sein, um die ersten Übertragungssymbole aus einem m-ären Modulationsalphabet zuzuweisen und die zweite Einrichtung zum Zuweisen zweiter Übertragungssymbole zu den Informationssymbolen des zweiten Teilstromes kann angepasst sein, um die zweiten Übertragungssymbole aus einem n-ären Modulationsalphabet zuzuweisen, wobei $m \leq n$ ist, und m, n natürliche Zahlen sind.

In anderen Ausführungsbeispielen können auch gleiche Modulationsalphabete eingesetzt werden, d.h. m=n. Die Übertragung mit unterschiedlichen Fehlerwahrscheinlichkeiten kann dann beispielsweise auch über unterschiedliche Sendeleistungen, die den Teilströmen, bzw. den Übertragungssymbolen der Teilströme zugeordnet werden, erreicht werden. In anderen Ausführungsbeispielen können zum Erreichen der verschiedenen Fehlerwahrscheinlichkeiten auch räumliche Konzepte eingesetzt werden, wie z.B. ein Zuordnen der Teilströme zu unterschiedlichen räumlichen Teilkanälen eines MIMO-Funkkanals. Generell können Ausführungsbeispiele den Teilströmen unterschiedlich robuste Funkressourcen zuordnen, die dann die unterschiedlichen Fehlerwahrscheinlichkeiten nach sich ziehen. Als Funkressourcen können hier, räumliche Kanäle, Frequenzen, Zeitschlitze, Codes, Sendeleistung, Modulationsalphabete, Redundanz usw. verstanden werden.

Wie bereits oben erwähnt, kann die Vorrichtung zum Zuweisen in einen Funk- oder Kabelsender integriert sein. Insbesondere in Kabelnetzen können unterschiedliche Ausbreitungsbedingungen herrschen. Beispielsweise ist in Kabelnetzen oftmals eine Empfangsqualität von einem Abstand eines Senders zu einem Empfänger abhängig. In einem solchen Ausführungsbeispiel wäre es denkbar, dass weiter entfernt liegende Empfänger lediglich einen Basisstrom mit akzeptabler Fehlerrate empfangen und näher gelegene Empfänger auch die Zusatzdaten mit akzeptabler Fehlerrate empfangen. Generell sind die Übertragungsbedingungen in Kabelnetzen variabel. Beispielsweise können unterschiedliche Ausbaustufen von Teilnetzen unterschiedliche Übertragungsbandbreiten vorsehen, sodass nicht alle Empfänger die volle Bandbreite unterstützen können. In Ausführungsbeispielen können demnach auch in schnurgebundenen Sendern und Empfängern, sogenannten Kabelsendern und Kabelempfängern, eingesetzt werden.

Dabei sind beispielsweise Rundfunksender, wie sie bei DVB zum Einsatz kommen, denkbar, als auch Basisstationen eines Mobilfunknetzes, beispielsweise im Rahmen von MBMS (MBMS = Mobile Broadcast Multicast Services) oder auch fest installierte Server bzw. Sender. In Ausführungsbeispielen kann der Sender ausgebildet sein, um die ersten und die zweiten Übertragungssymbole als Rundfunkübertragung zu übertragen.

In analoger Weise können Ausführungsbeispiele der vorliegenden Erfindung auch Vorrichtungen zum Schätzen eines Mediadatenstromes basierend auf einem Strom von Empfangssymbolen umfassen, wobei die Vorrichtung zum Schätzen einen Demultiplexer zum Aufspalten des Stromes von Empfangssymbolen in wenigstens einen ersten Teilsymbolstrom und einen zweiten Teilsymbolstrom aufweist. Die Vorrichtung umfasst ferner einen ersten Symbolschätzer zum Zuordnen eines ersten Teilstromes von Informationssymbolen des Mediadatenstromes zu dem ersten Teilsymbolstrom, basierend auf einem ersten Symbolalphabet. Darüber hinaus weist die Vorrichtung einen zweiten Symbolschätzer auf, zum Zuordnen eines zweiten Teilstromes von Informationssymbolen des Mediadatenstromes zu dem zweiten Teilsymbolstrom, basierend auf einem zweiten Symbolalphabet.

Das zweite Symbolalphabet kann dabei eine größere Anzahl von Symbolen als das erste Symbolalphabet umfassen. Der erste Teilstrom erlaubt dabei eine Darstellung eines Mediainhaltes in einer Basisqualität, der zweite Teilstrom zusammen mit dem ersten Teilstrom erlaubt eine Darstellung des Mediainhaltes in einer verbesserten Qualität. Gemäß obiger Erläuterung kann das erste Symbolalphabet einem m-ären Modulationsalphabet und das zweite Symbolalphabet einem n-ären Modulationsalphabet entsprechen, wobei $m \leq n$ ist und m, n natürliche Zahlen sind. In anderen Ausführungsbeispielen sind auch gleich große Symbolalphabete, m=n, denkbar.

Die Übertragung mit unterschiedlicher Robustheit oder Fehlerwahrscheinlichkeiten kann z.B. auch über unterschiedliche Sendeleistungen, die den Teilströmen, bzw. den Übertragungssymbolen der Teilströme zugeordnet werden, erreicht werden. In einem solchen Ausführungsbeispiel wäre das Verwenden gleicher Symbolalphabete denkbar.

In anderen Ausführungsbeispielen können zum Erreichen der verschiedenen Fehlerwahrscheinlichkeiten auch räumliche Konzepte eingesetzt werden, wie z.B. ein Zuordnen der Teilströme zu unterschiedlichen räumlichen Teilkanälen eines MIMO-Funkkanals. Auch dann wäre der Einsatz gleicher Symbolalphabete der Teilströme denkbar.

Die Vorrichtung zum Schätzen kann in einen Funk- oder Kabelempfänger integriert sein, wobei es sich bei dem Empfänger um ein mobiles Endgerät, wie beispielsweise einem Mobilfunktelefon oder einem PDA (PDA = Personal Digital Assistent) handeln kann. Ausführungsbeispiele sind nicht beschränkt auf Mobilfunkendgeräte, beispielsweise sind auch Fernsehgeräte, Desktop-Computer, tragbare Computer, wie beispielsweise Laptops oder auch Navigationssysteme, denkbar.

Im folgenden werden Ausführungsbeispiele der vorliegenden Erfindung im Detail anhand eines skalierbaren Videodatenstromes erläutert. Beispielsweise in T. Schierl, T. Stockhammer, and T. Wiegand, "Mobile video transmission using scalable video coding", IEEE Trans. Circuits Syst. Video Technol., vol. 17, no. 9, pp. 1204-1217, 2007, wird ein dreischichtiges skalierbares SVC-Verfahren vorgestellt, welches in analoger Weise zur Fig. 1 einen ersten Layer oder eine erste Schicht mit 160 kBit/s, eine zweite Schicht mit 200 kBit/s und eine dritte Schicht mit ebenfalls 200 kBit/s umfasst. Dabei sind Layer 2 und 3, d.h. Schicht 2 und Schicht 3, ausgelegt, um Zusatzdaten zu liefern. Prinzipiell sind Ausführungsbeispiele jedoch nicht auf diese spezielle Videocodierung oder diese Datenraten beschränkt.

Im folgenden Ausführungsbeispiel werden verschiedene Modulationsalphabete für die Teilströme, d.h. die Schichten 1 bis 3 verwendet. Allgemein bieten auch Ausführungsbeispiele den Vorteil, dass beispielsweise bei einer sinkenden Kanalqualität, d.h. wenn beispielsweise durch Abschattung oder andere Effekte Übertragungsfehler auftreten, zwar weniger Schichten dekodiert werden können, aber fehlerhafte Layer verworfen werden können. Die restlichen Layer oder Schichten können dann dekodiert werden und die Mediainhalte in einer verminderten Qualität dargestellt werden. Eine Adaption an den Übertragungskanal wird durch Ausführungsbeispiele somit in Empfängern ermöglicht.

Zu einer Übertragung über einen Übertragungskanal, können beispielsweise bekannte Konzepte wie OFDM (OFDM = Orthogonal Frequency Division Multiplexing) in zellularen Netzwerken verwendet werden, wie beispielsweise in konventionellen terrestrischen Rundfunknetzen, wie z.B. DVB-T, vgl. ETSI EN 300 744 v1.5.1, "Digital video broadcasting (DVB); framing structure, channel coding and modulation for digital terrestrial television, "European Standard, 11 2004. Ferner können zellulare Gleichfrequenznetze SFN (SFN = Single Frequency Network), zum Einsatz kommen, die es erlauben, die gleiche Frequenz in jeder Zelle wiederzuverwenden, jedoch weniger flexibel hinsichtlich der Übertragung von individueller Information, d.h. dedizierter Information zum einzelnen Teilnehmern, wie beispielsweise bei personalisierter Werbung, sind.

In Ausführungsbeispielen können Übertragungskonzepte die dem Mobilfunk entstammen, mit Rundfunkkonzepten kombiniert werden. Beispielsweise wurde in den vergangenen Jahren im Bereich des Mobilfunks eine höhere spektrale Effizienz und eine bessere Abdeckung erreicht. Beispielsweise wurden hier MIMO-Konzepte (vgl. I.E. Teletar, "Capacity of multi-antenna gaussian channels", European Transactions on Telecommunication, vol. 10, no. 6, pp. 585-596, 1999), Raum-Zeit-Codierung (vgl. B. Hassibi and B.M. Hochwald, "High-rate codes that are linear in space and time," IEEE Trans. Inf. Theory, vol. 48, no. 7, pp. 1804-1824, 2002) und Basisstations-Kooperation (BS = Basisstation), in manchen Zusammenhängen auch Makrodiversität genannt (vgl. S. Shamai and B. Zaidel, "Enhancing the cellular downlink capacity via coprocessing at the transmitting end," Proc. IEEE VTC '01 Spring, vol. 3, pp. 1745-1749, 2001).

In V. Jungnickel, S. Jaeckel, L. Thiele, U. Krüger, A. Brylka and C. Helmolt, "Capacity measurements in a multicell MIMO system," (Proc. IEEE Globecom '06, 2006) werden Messergebnisse präsentiert, die zeigen, dass zusätzliche Kapazitätsgewinne erzielt werden können, in sogenannten Rang-reduzierten LOS-MIMO-Kanälen (LOS = Line Of Sight, direkte Sichtverbindung) unter Verwendung von Polarisationsmultiplex. Wie bereits oben erläutert, wurde auch die Videocodierung substantiell verbessert.

Beide Konzepte können geschichtete Übertragung, d.h. eine Übertragung in mehreren Layern oder Schichten, verwenden. Beispielsweise können MIMO-Systeme mehrere Schichten in der Raum-Zeit-Frequenzdomäne bereitstellen, auf die in Ausführungsbeispielen die einzelnen Teilströme abgebildet werden können. Im folgenden Ausführungsbeispiel mit den Schichten eines SVC-Media-Datenstroms wird derart verfahren. Generell ist anzumerken, dass hochauflösende Videodaten hohe Übertragungsraten, wie beispielsweise mehrere MBit/S umfassen können, aber breitbandige Funkkanäle, welche für die Übertragung der hohen Datenraten benötigt werden, unzuverlässig sind. Dieser Nachteil kann in Ausführungsbeispielen durch verschiedene Technologien, wie beispielsweise KanalCodierung, räumliche Diversität, zeitliche Diversität, Frequenzdiversität, usw. kompensiert werden.

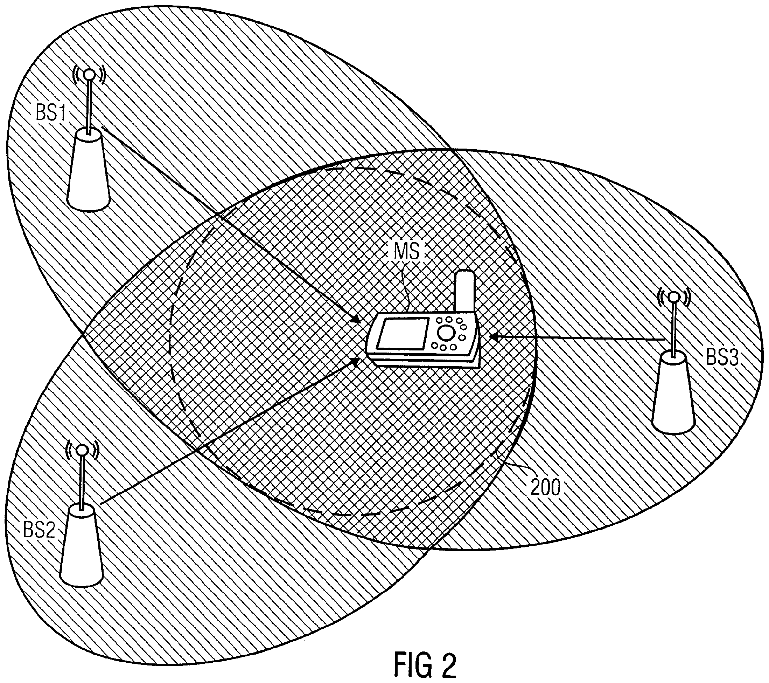

Im Folgenden werden einige dieser Konzepte näher erläutert, wobei Ausführungsbeispiele nicht generell auf diese Konzepte begrenzt sind. In Ausführungsbeispielen können sogenannte Gleichwellennetzwerke (englisch: single frequency networks) zum Einsatz kommen. Das Konzept von Gleichwellennetzwerken ist beispielhaft in der Fig. 2 gezeigt. Die Figur 2 zeigt drei Basisstationen, die mit "BS1", "BS2" und "BS3" bezeichnet sind. Die Fig. 2 zeigt ferner eine Mobilstation, die mit "MS" bezeichnet ist. Alle drei Basisstationen senden im Gleichfrequenznetzwerk das gleiche Signal. In einer zentralen Region zwischen den Basisstationen, die in Fig. 2 durch eine gestrichelte Linie 200 angedeutet ist, können die Signale aller Basisstationen empfangen werden. Die Mobilstation befindet sich in diesem Bereich und enthält somit drei unabhängige Kopien des gleichen Signals, wodurch ein Diversitätsgewinn erzielbar ist. Die Signale der drei Basisstationen können als zusätzliche Mehrwegekomponenten des Mobilfunk-Kanals betrachtet werden.

In anderen Worten senden in kohärenten Gleichfrequenznetzwerken mehrere Sender das gleiche Signal über die gleiche Frequenz. Dies ermöglicht eine größere Anzahl von Radio- oder Fernsehkanälen im Vergleich zu konventionellen Mehrfrequenznetzwerken (MFN = Multi Frequency Network, Mehrfrequenznetzwerk), bei denen pro Sender nicht die volle Bandbreite zur Verfügung steht. Am Empfänger, am Beispiel der Fig. 2 an der Mobilstation MS, kann die Gleichfrequenzübertragung wie eine Mehrwegeausbreitung betrachtet werden. Insbesondere in Ausführungsbeispielen, die OFDM-Konzepte verwenden, können so lange die künstlich erzeugten Multipfadkomponenten innerhalb des Schutzintervalls liegen, das auch Guard-Intervall oder Cyclic Prefix genannt wird, erhöhen diese die insgesamte Empfangsleistung. Aufgrund der unabhängigen Pfade, d.h. der unabhängigen Kopien des gleichen Sendesignals, kann Diversität ausgenutzt werden, in anderen Worten eine höhere Diversitätsordnung erzielt werden.

Terrestrische digitale TV (TV = television) Rundfunksysteme können OFDM-SFNs benutzen. Diese Systeme können Frequenzdiversität ausnutzen, da die Bandbreite der OFDM-Komponente die Kohärenzbandbreite des Funkkanals überschreitet, und sind vergleichsweise einfach zu implementieren, da OFDM-Konzepte bereits bekannt sind. Nichtsdestoweniger nutzen diese Systeme die Gewinne, die in der räumlichen Ebene erzeugbar sind, nicht aus. Ausführungsbeispiele nutzen jedoch zusätzlich auch räumliche Diversität aus, wie beispielsweise durch die unkorrelierten Pfade oder Signalkopien, die von mehreren Basisstationen ausgesendet werden, wie anhand der Fig. 2 beschrieben. Konventionelle Konzepte, wie beispielsweise der DVB-T-Standard, sehen auch keine Mehrantennenkonzepte vor, wie beispielsweise räumliche Multiplex- und Diversitätscodierungskonzepte vor. Gemäß obiger Erläuterung können Gleichfrequenznetzwerke wie eine besondere Form von Mehrwegeausbreitung betrachtet werden.

Ausführungsbeispiele können ferner Polarisationsdiversität ausnutzen. Polarisationsdiversität bietet eine weitere Möglichkeit, um den Gesamtdiversitätsgewinn weiter zu verbessern. Beispielsweise können in Ausführungsbeispielen an Empfängern, wie beispielsweise Mobilfunkendgeräten, zwei oder mehrere Empfangsantennen zum Einsatz kommen. Beispielsweise in V. Jungnickel, S. Jaeckel, L. Thiele, U. Krüger, A. Brylka, and C. Helmolt, "Capacity measurements in a multicell MIMO system," (Proc. IEEE Globecom ,06, 2006) werden Messergebnisse präsentiert, die zeigen, dass zumindest zwei Freiheitsgrade in einem Rang-reduzierten LOS-Kanal existieren, wenn kreuzpolarisierte Antennen sowohl am Sender als auch am Empfänger benutzt werden. Der hieraus resultierende Diversitätsgewinn resultiert aus der Tatsache, dass kreuzpolarisierte Kanäle zu einem gewissen Grad unkorreliert sind. Wenn der Empfänger in der Lage ist, die Signale einer horizontalen und einer vertikalen Polarisationsebene separat zu empfangen, kann beispielsweise durch eine Maximalratenkombination (MRC = Maximum Ratio Combining) die eine kohärente Überlagerung der Signale der Polarisationsebenen ermöglicht, ein entsprechender Gewinn erzielt werden.

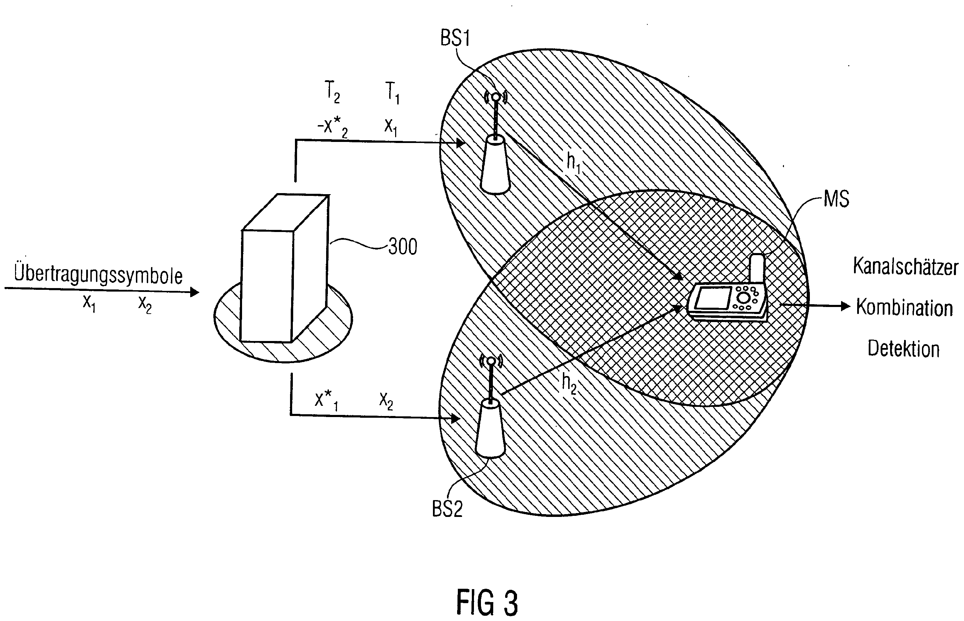

Ausführungsbeispiele können ferner Raum-Zeit-Codierung ausnutzen (STC = Space Time Coding), wie beispielsweise in Form eines Alamouti-Schemas (vgl. S. Alamouti, "A simple transmit diversity technique for wireless communications", IEEE J. Sel. Areas Commun, vol. 16, no. 8, pp. 1451-1458, 1998). Raum-Zeit-Codierung ermöglicht zusätzliche Diversitätsgewinne am Empfänger, durch eine in Raum und Zeit verschachtelte Codierung der Signale am Sender, man spricht auch von open loop transmit diversity. Dieses Konzept wird anhand der Fig. 3 näher erläutert. Die Fig. 3 zeigt zwei Basisstationen, die mit "BS1" und "BS2" bezeichnet sind. Die Fig. 3 zeigt ferner eine Mobilstation, die mit "MS" bezeichnet ist. Zunächst werden zwei zeitlich aufeinanderfolgende Übertragungssymbole $x_1$ und $x_2$ einem Raum-Zeit-Codierer 300 zugeführt.

Der Raum-Zeit-Codierer 300 ist mit den beiden Basisstationen BS1 und BS2 verbunden. Während eines ersten Zeitraums, der in der Fig. 3 mit $T_1$ bezeichnet ist, werden von der Basisstation BS1 das komplexe Übertragungssymbol $x_1$ und von der Basisstation BS2 das komplexe Übertragungssymbol $x_2$ gesendet. Zwischen der Basisstation BS1 und der Mobilstation wird ein Übertragungskanal angenommen, der in der Fig. 3 mit $h_1$ modelliert ist. Zwischen der Basisstation BS2 und der Mobilstation MS wird analog ein Übertragungskanal angenommen, der durch $h_2$ modelliert ist. Während eines zweiten Zeitraumes, der in der Fig. 3 mit $T_2$ bezeichnet ist, werden nun von der Basisstation BS1 aus das negierte konjugiert komplexe Übertragungssymbol $-x^*_2$ und von der Basisstation BS2 aus das konjugiert komplexe Übertragungssymbol $x^*_1$ übertragen.

Dieses Schema entspricht dem von Alamouti gefundenen Übertragungsschema, das es dem Empfänger erlaubt, zunächst die beiden Übertragungskanäle $h_1$ und $h_2$ zu schätzen, und dann durch Kombination der während der Zeiträume $T_1$ und $T_2$ empfangenen Signale, sowohl $x_1$ als auch $x_2$ zu bestimmen. Die Codierung nach Alamouti erlaubt dabei, durch Addition, resp. Subtraktion, der beiden überlagerten Signale aus den Zeiträumen $T_1$ und $T_2$ jeweils Signalkomponenten des gleichen Übertragungssymbols konstruktiv zu überlagern und gleichzeitig diejenigen des anderen Übertragungssymbols destruktiv zu überlagern. Dabei entsteht ein Diversitätsgewinn, da in dem überlagerten Signal Signalanteile vorhanden sind, die über unabhängige Kanäle $h_1$ und $h_2$ übertragen wurden. Dieses einfache Schema erlaubt die kohärente Kombination der beiden Empfangspfade selbst wenn nur eine Empfangsantenne an der Mobilstation MS zur Verfügung steht. Die entsprechende Kombination aus den Signalen kann dann zur Detektion einem Detektor zur Verfügung gestellt werden.

In Ausführungsbeispielen kann ein weiteres Konzept, der sogenannte Polarisationsmultiplex, zum Einsatz kommen. Hierbei werden kreuzpolarisierte Antennen am Sender, d.h. an der Basisstation verwendet. Wenn die Mobilstation ebenfalls kreuzpolarisierte Antennen verwendet, so können zwei Datenströme oder Teil-Datenströme in der räumlichen Ebene gemultiplext werden. Jede Basisstation sendet dann einen Teilstrom in der horizontalen Polarisationsebene und einen anderen Teilstrom in der vertikalen Polarisationsebene. Durch die Mehrwegeausbreitung können die Polarisationsvektoren bei der Übertragung über den Mobilfunkkanal ihre Polarisationsrichtung ändern, dies kann jedoch durch entsprechende Kanalschätzungskonzepte zusammen mit MIMO-Entzerrung kompensiert werden, wodurch die beiden Teilströme am Empfänger separierbar werden. Dabei können beispielsweise benachbarte Basisstationen das gleiche Signal gemäß einem Gleichfrequenzmodus aussenden, es sind aber auch andere Konzepte, wie beispielsweise eine 6x2 Raum-Zeit-Codierung zur gemeinsamen Übertragung in einer Zelle denkbar, 6x2 STC for joint transmission. Beide Konzepte wären in der Lage, Frequenzdiversität und räumliche Diversität gleichzeitig auszunutzen.

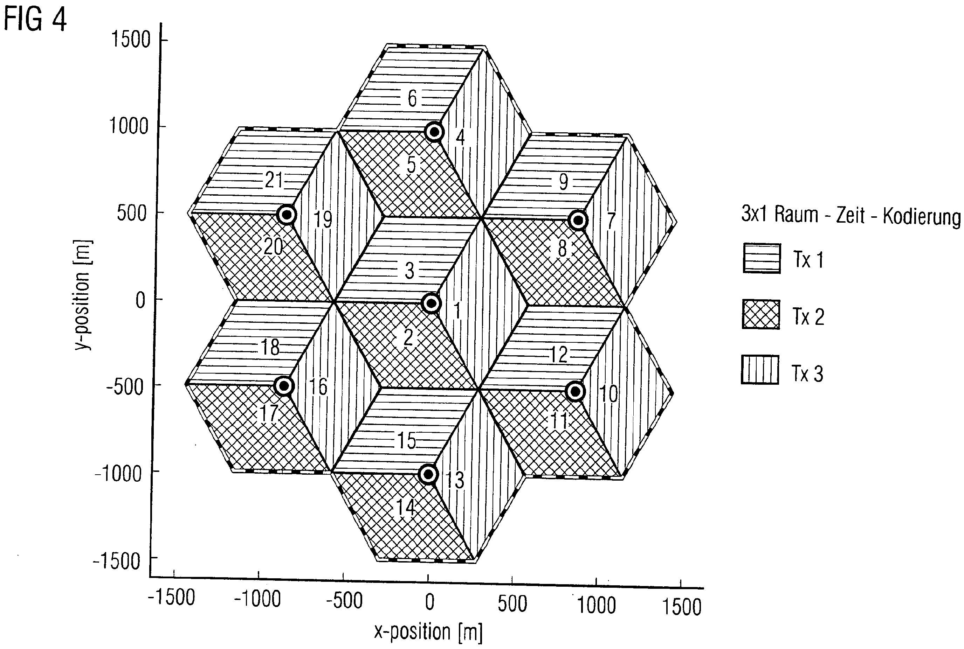

In Ausführungsbeispielen kann zusätzlich Makrodiversität ausgenutzt werden, wie es im Folgenden anhand der Fig. 4 näher erläutert werden soll. Zur Erzielung einer höheren Diversitätsordnung kann beispielsweise ein 3x1 oder ein 6x1 Raum-Zeit-Code implementiert werden, der sich über mehrere benachbarte Basisstationen erstreckt. Die Fig. 4 zeigt eine Anordnung von mehreren Basisstationen in einer xy-Ebene, wobei die x-Position und die y-Position jeweils in Metern angegeben sind. Fig. 4 zeigt eine hexagonale Netzwerkstruktur, die von sieben Basisstationsstandorten ausgeht, die sich jeweils im Zentrum eines Hexagons befinden. Ferner wird in der Fig. 4 davon ausgegangen, dass sich an jedem Basisstationsstandort Basisstationen befinden, so dass sich insgesamt in der Fig. 4 21 Basisstationen befinden. Die in der Fig. 4 gezeigte Struktur wird auch englisch "cluster" genannt.

Makrodiversität lässt sich an dieser Stelle beispielsweise durch einen 3x1 Raum-Zeit-Code ausnutzen. Dies bedeutet, dass verschiedene Zeitschemata, die sich im in der Fig. 4 gezeigten Ausführungsbeispiel über drei Zeitschlitze erstrecken, einzelnen Basisstationen zugeordnet sind. Fig. 4 illustriert die zugehörige Codeplanung, durch in unterschiedlichen Grautönen hinterlegte Zellbereiche. Es lässt sich erkennen, dass an den Schnittpunkten der einzelnen Zellbereiche jeweils drei unterschiedliche Space Time Codes oder Raum-Zeit-Codes aufeinandertreffen, so dass ein entsprechender Empfänger die bereits oben beschriebenen Konzepte ausnutzen kann. Beispielsweise kann ein Mobilfunkendgerät die Kenntnis der einzelnen Kanäle, die durch Kanalschätzung zu den einzelnen Basisstationen ermittelt werden können, ausnutzen, um die Empfangsleistungen der unabhängigen Kanäle kohärent zu kombinieren. Wie bereits oben beschrieben liefert dies ein verbessertes Signal-Rausch-Verhältnis (SNR = Signal-to-Noise-Ratio) und kann somit auch einem Netzwerkbetreiber dazu verhelfen, höherwertige Modulationsalphabete, wie beispielsweise 64- oder 256-QAM (QAM = Quadrature Amplitude Modulation) zur Verbesserung des Datendurchsatzes zu verwenden.

An Ausführungsbeispielen können verschiedene Übertragungstechniken zum Einsatz kommen. An einem Ausführungsbeispiel kann beispielsweise eine DFT-Spreizung verwendet werden (DFT = Diskrete Fourier-Transformation). Spreizverfahren bieten eine generelle Möglichkeit zur Verbesserung der Übertragungseigenschaften verschiedener Bitströme. Ein bekanntes Konzept ist das sogenannte CDMA (CDMA = Code Division Multiple Access), wobei ein niederratig moduliertes Signal mit hochratigen binären Codesequenzen, den sog. Spreizsequenzen, multipliziert wird. Das Übertragungssignal weist dabei eine größere Bandbreite auf als das Informationssignal und wird somit robuster gegen Übertragungsfehlern, insbesondere im Mehrwegekanal mit schnellem Schwund.

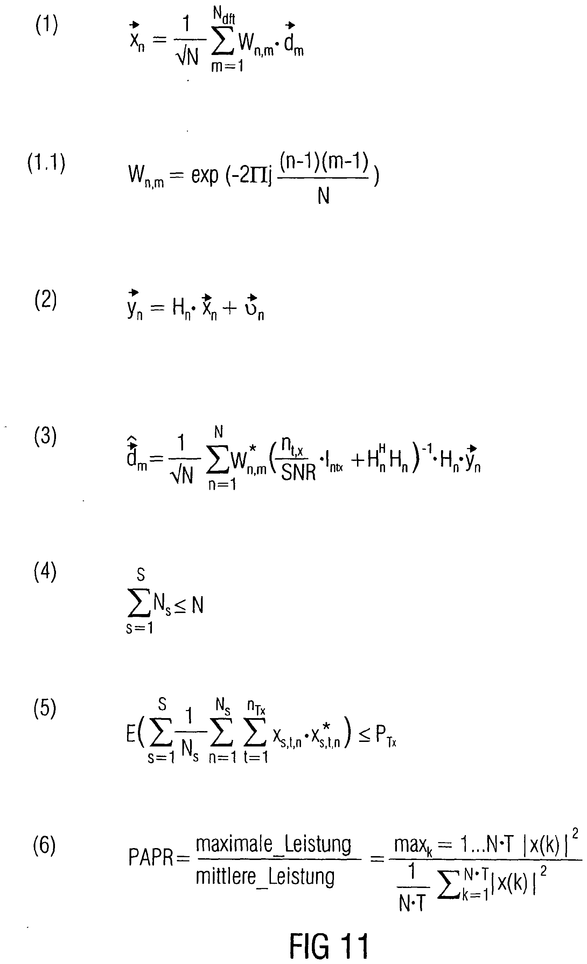

Die verwendeten Codesequenzen können paarweise orthogonal sein, die Rekonstruktion des Informations- oder Eingangssymbolstromes wird dann zu einem einfachen Multiplikationsprozess des Empfangssignals mit der gleichen Codesequenz, sowie einer Addition über eine Sequenzlänge. Mit der vermehrt zur Verfügung stehenden Rechenleistung können in Ausführungsbeispielen auch nichtbinäre Spreizsequenzen in Echtzeit verwendet werden. Kandidaten für solche Spreizsequenzen können beispielsweise von der diskreten Fourier-Transformation abgeleitet werden, daher der Name DFT-Spreizung. Dies kann beispielsweise durch eine unitäre diskrete Fourier-Transformation eines Datensymbolvektors $\vec{d}_m$ erfolgen, wie es in der Fig. 11 in Gleichung 1 gezeigt ist, wobei $W_{n,m}$ die skalaren Koeffizienten der diskreten Fourier-Transformationsspreizsequenz sind mit den Komponenten gemäß Fig. 11 Gleichung 1.1.

In den Gleichungen entspricht $N_{dft}$ der Anzahl der Eingangssymbole der diskreten Fourier-Transformation, der Leistungsskalierfaktor $1/\sqrt{N}$ dient der Leistungsbegrenzung des OFDM-Systems. Die Länge des Vektors von Datensymbolen $\vec{d}_m$ und $\vec{x}_n$ gleichen der Anzahl der parallelen Übertragungsströme in der räumlichen Ebene, z.B. der Anzahl von Sendeantennen in einem MIMO-Mulitplexsystem. Nach Übertragung durch einen MIMO-OFDM-Funkkanal hat jedes der N-Übertragungssymbole einen frequenzselektiven Schwund erfahren, der beispielsweise durch die (Schmalband) MIMO-Übertragungsgleichung für jeden der OFDM-Unterträger ausgedrückt werden gemäß der Fig. 11 Gleichung 2 (I.E. Telatar, "Capacity of multi-antenna gaussian channels", European Transactions on Telecommunications, vol. 10, no. 6t, pp. 585-596, 1999).

In Fig. 11 Gleichung 2 entspricht $\vec{y}_n$ dem Empfangssymbolvektor $H_n{=}n_{Tx}\times n_{Rx}$ der Kanalmatrix in den Dimensionen der Anzahl der Sendeantennen $n_{Tx}$ und der Anzahl der Empfangsantennen $n_{Rx}$, und $\vec{v}_n$ ist additives Rauschen. Eine Entzerrung kann nach dem minimalen Fehlerquadratkonzept erfolgen (MMSE = Minimum Mean Square Error, vgl. A. van Zelst, "Space division multiplexing algorithms", Proc. IEEE MeleCon ,00, vol. 3, pp. 1218-1221, 2000) und DFT-Entspreizung führt dann zu einem geschätzten Datensymbol im Empfänger gemäß der Fig. 11 Gleichung 3. In der Fig. 11 Gleichung 3 entspricht $\mathbf{W}^*_{n,m}$ der komplex konjugierten von $\mathbf{W}_{n,m}$. Es lässt sich beweisen, dass eine Entzerrung im Frequenzbereich und anschließende inverse diskrete Fourier-Transformation-Entspreizung die gleiche Qualität liefert wie ein RAKE-Multiuser-Detektor der auf einer DFT-Spreizsequenz basiert, vgl. S. Jaeckel und V. Jungnickel, "On the optimality of frequency-domain equalization in DFT-spread MIMO-OFDM systems", Proc. IEEE WCNC, '08, 2008. Zumindest theoretisch kann so der maximal erreichbare Diversitätsgewinn erzielt werden, durch kohärentes Kombinieren der Leistungen von mehreren Mehrwegekomponenten. Dies kann insbesondere in solchen Ausführungsbeispielen vorteilhaft sein, die auch SFN-Übertragung verwenden in einem Rundfunknetzwerk, um die Anzahl der Mehrwegekomponenten zu erhöhen.

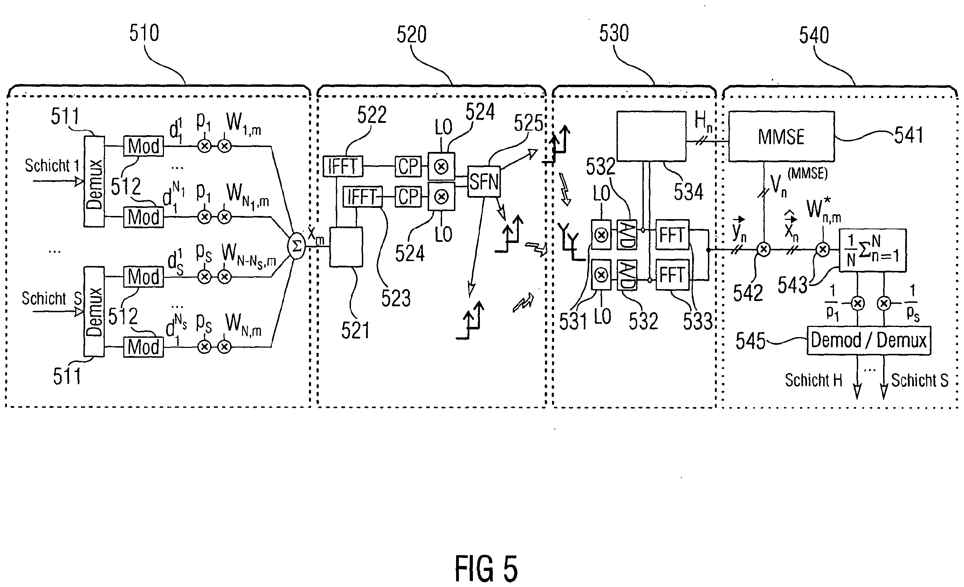

Die Fig. 5 zeigt ein Blockschaltbild eines Ausführungsbeispiels einer Signalübertragungskette. In einem ersten Block 510 wird ein Einträgerfrequenzbereich-Multiplex durchgeführt (SC-FDM = Single Carrier-Frequency Division Multiplexing). Im Datenverarbeitungsblock 510 kommen zunächst von der linken Seite aus gesehen die Datenströme der Teilströme der Mediadaten an. In der Fig. 5 wird beispielhaft von S Schichten ausgegangen. Zunächst werden die Symbole der einzelnen Schichten gedemultiplext, was in den Blöcken 511 geschieht. Mit anderen Worten wird hier eine den Informationssymbolen der einzelnen Schichten Seriell-Parallel-Wandlung durchgeführt. Anschließend werden Modulations- oder Übertragungssymbole zugeordnet, was in den Blöcken 512 geschieht. Die daraus resultierenden Datensymbole $d_n$ werden durch Leistungsfaktoren $p_n$ gewichtet und dann mit den bereits beschriebenen DFT-Spreizsequenzen $\boldsymbol{W}_{n,m}$ in den Frequenzbereich transformiert und addiert.

In der Fig. 5 zeigt der Block 520 einen Raum-Zeit-Codierer 521, der das Ausgangssignal des Blocks 510 entsprechend codiert. Dem Raum-Zeit-Codierer nachgeschaltet sind in jedem der zwei Sendezweige ein IFFT 522, ein Block 523 zum Einfügen des Schutzintervalls (CP = Cyclic Prefix), je ein Lokaloszillator 524 zum Mischen des Basisbandsignals in das Übertragungsband, woraufhin ein SFN 525 folgt. Die Blöcke 510 und 520 ergeben somit die Signalverarbeitungskette in einem Sender.

Die Fig. 5 zeigt ferner zwei Signalverarbeitungsblöcke 530 und 540, die zusammen in einem Empfänger implementiert sein können. In Block 530 wird nun beispielsweise über zwei Senderantennen ein Empfangssignal empfangen. In jedem Empfangszweig befindet sich ein Lokaloszillator 531, der von einem Analogdigitalwandler 532 gefolgt ist. Dem Analogdigitalwandler sind dann zwei FFTs 533 nachgeschaltet, die das Diskretbasisbandsignal in den Frequenzbereich transformieren. Parallel zu den FFTs 533 erfolgt eine Kanalschätzung bzw. Raum-Zeit-Decodierung im Block 534, wobei der geschätzte Kanal $\mathbf{H}_n$ und das Frequenzbereichsempfangssignal $y_n$ an den Block 540 übergeben werden. Im Block 540 findet zunächst eine Frequenzbereichsentzerrung statt, die durch eine entsprechende MMSE-Gewichtungsberechnung 541 mit nachfolgender Multiplikation auf das Empfangssignal 542 erfolgt. Anschließend kann durch eine inverse DFT 543 eine DFT-Entspreizung durchgeführt werden, wodurch wiederum der Strom von Symbolen parallelisiert und in die einzelnen Teilströme aufgeteilt wird, die den einzelnen Schichten zugeordnet und beispielsweise noch leistungsskaliert sind. Nachfolgend kann eine Leistungsdeskalierung 544 folgen, woraufhin die Informationssymbole der einzelnen Teilströme in einem Block 545 geschätzt und gedemultiplext werden können.

Ausführungsbeispiele können sogenanntes Einträger-Multiplex oder Gleichfrequenzmultiplex verwenden. In Mobilfunksystemen, wie z.B. dem 3GLTE (3GLTE = 3rd Generation Long Term Evolution) werden sowohl individuelle Teilnehmerdaten als auch Rundfunkdaten gleichzeitig übertragen. Beide Datentypen können dabei den gleichen Frequenzbereich verwenden, z.B. durch ein Vielfachzugriffsverfahren im Zeitbereich (z.B. TDMA = Time Division Multiple Access). Die Dauer eines einzelnen Zeitschlitzes kann dabei derart gewählt werden, dass der zu sendende Rundfunkverkehr, beispielsweise die Anzahl bereitstehender Programme, bzw. der Punkt-zu-Punkt-Verbindungen berücksichtigt wird. Während einem Zeitschlitz hat das Rundfunksystem vollen Kanalzugriff und kann somit die oben beschriebenen Diversitätskonzepte verwenden, beispielsweise auch spezielle Pilottöne oder -symbole, Raum-Zeit-Codierung und Kanalcodierung, erweiterte Schutzintervalle, Modulationsschemen usw.

SC-FDM kann somit benutzt werden, um mehrere Schichten eines Video-Datenstromes in einen einzelnen Träger zu multiplexen, vgl. auch V. Jungnickel, T. Hindelnag, T. Haustein und W. Zirwas, "SC-FDMA waveform design, performance, power dynamics and evolution to MIMO", Proc. IEEE Portable ,07, 2007.

Die Fig. 5 zeigt dabei eine generelle SC-FDM Übertragungs- oder Signalverarbeitungskette. Wie bereits oben erläutert, werden die einzelnen Schichten der skalierbaren Videodaten getrennten Modulations- oder Übertragungssymbolen zugewiesen, wobei auch verschiedene Kanalcodierungskonzepte für die einzelnen Schichten zum Einsatz kommen können. In anderen Worten können Ausführungsbeispiele von Sendern oder Funksendern Kanalkodierer aufweisen, die ausgebildet sind, um dem ersten oder dem zweiten Teilstrom unterschiedliche Redundanz hinzuzufügen. In analoger Weise kann ein Empfänger, ein Funkempfänger oder ein Kabelempfänger, gemäß einem Ausführungsbeispiel einen Kanaldekodierer aufweisen, der ausgebildet ist, um unterschiedliche Größenordnungen von Redundanz bei der Dekodierung der Teilströme zu berücksichtigen.

Zusätzlich können Ausführungsbeispiele von Sendern oder Funksendern eine Leistungssteuerung aufweisen, um den Übertragungssymbolen des ersten und des zweiten Teilstroms unterschiedliche Sendeleistungen zuzuordnen. In einem Ausführungsbeispiel kann die Leistungsskalierung derart angewendet werden, dass Schichten mit einem höheren Modulationsgrad, d.h. einem größeren Modulationsalphabet (QAM) gleichzeitig weniger Leistung bekommen. Ausführungsbeispiele verbessern somit die Dynamik der unterschiedlichen Kanalkodierungen der Teilströme und können ferner eine insgesamte Dynamik des Signals, die auch Peak-to-Average Power Ratio (PAPR = Peak-to-Average Power Ratio) genannt wird, in dem zusammengesetzten Einträgersignal verbessern, wobei die Dynamik maßgeblich durch die Modulationsalphabete der höheren Ordnungen beeinflusst wird, wie z.B. 16- oder 64-QAM.

Wie bereits erwähnt, kann in Ausführungsbeispielen auch eine ungleiche Fehlercodierung, die auch unequal error protection genannt wird, zum Einsatz kommen. In einem Ausführungsbeispiel können hierarchische Kodierungs-Konzepte zum Einsatz kommen, wie beispielsweise im SVC, wo es nur möglich ist, Schicht 2 zu dekodieren, wenn die Schicht 1 korrekt dekodiert wurde, in analoger Weise kann die Schicht 3 nur dekodiert werden, wenn die Schichten 1 und 2 bereits korrekt dekodiert wurden. Obwohl es generell schwierig ist, in einem Rundfunksystem die Übertragungskonzepte an den Kanal anzupassen, kann in Ausführungsbeispielen eine Anpassung an die Quelle erfolgen. Durch Zuordnung mehrerer Funkressourcen, z.B. durch Benutzen einer größeren Bandbreite, QPSK (QPSK = Quadrature Phase Shift Keying) anstatt 16-QAM-Modulation, usw. kann die Übertragungsqualität beispielsweise der Schicht 1 entscheidend beeinflusst werden. Gleichzeitig kann jedoch die Übertragungsqualität einer höheren Schicht entsprechend abnehmen. Zur Berechnung der Modulations- und Kodierungsparameter können die folgenden Bedingungen herangezogen werden.

Zunächst spielt die Gesamtanzahl der verfügbaren Ressourcen eine Rolle. Wenn beispielsweise N-Funkressourcen, z.B. Eingänge des DFT-Encoders, zur Verfügung stehen, lassen sich auch N-komplexe Modulationssymbole generieren. Die Anzahl der verfügbaren Ressourcen auf jedem Layer ist dann limitiert, wie es in der Fig. 11 gemäß Gleichung 5 angegeben ist, in welcher S der Anzahl der Schichten entspricht und $N_s$ gleich der Nummer der einer Schicht s zugeordneten Ressourcen ist.

Ein weiterer Faktor kann die ankommende SVC-Datenrate pro Teilstrom sein. Jeder SVC-Teilstrom hat eine bestimmte Anzahl von Bits, die während eines vorgegebenen Übertragungsintervalls, das auch TTI (TTI = Transmission Time Interval) genannt wird, verarbeitet werden. Das Modulationsformat, z.B. BPSK (BPSK = Binary Phase Shift Keying), QPSK, 16-QAM, usw. und die Anzahl der zugeordneten Funkressourcen, wird entsprechend zugeordnet. Zusätzlich kann im Rahmen einer Vorwärtsfehlerkorrektur (FEC = Forward Error Correction), Redundanz zu den einzelnen Teilströmen hinzugefügt werden, und zwar im Rahmen verschiedener Codiervorschriften. Dazu können entsprechende minimale Anzahlen von Bits pro Übertragungspaket, das auch Paket Data Unit (PDU = Paket Data Unit) genannt wird, berücksichtigt werden.

Ein weiterer Faktor kann der Unterschied in den gewünschten Bitfehlerraten (BER = Bit Error Ratio) zwischen den jeweiligen Teilströmen sein. Zwei SVC-Schichten können in Ausführungsbeispielen unterschiedliche Bitfehlerraten erreichen. Damit können unterschiedliche Signalrauschverhältnisse bzw. ein Signalrauschverhältnis-Offset bzw. -Versatz zwischen den einzelnen Teilströmen aufgrund der verschiedenen Modulationsformate verbunden sein. Zum Beispiel kann 16 QAM eine geringere Übertragungsqualität erzielen als beispielsweise QPSK. Zu berücksichtigen ist hierbei jedoch auch die den einzelnen Teilströmen zugeordnete Sendeleistung $P_s$, worauf im folgenden noch eingegangen wird.

Ferner ist es vorteilhaft, wenn die Leistungsbegrenzung des OFDM-Systems berücksichtigt wird. Die Sendeleistung ist generell in Mobilfunksystemen beschränkt. Wenn Skalierungsfaktoren der Leistungsskalierung der einzelnen Teilströme betrachtet wird, so sollte dabei die Gesamtleistung eine gewisse Schranke nicht überschreiten. Dies ist in der Fig. 11 in Gleichung 5 veranschaulicht, in der $n_{Tx}$ die Anzahl der Sendeantennen ist, $N_s$ die Anzahl der Datenströme und $P_{Tx}$ der Gesamtsendeleistung entspricht.

Ein weiterer Faktor ist das Verhältnis aus Spitzenleistung zu durchschnittlicher Leistung, das auch PAPR genannt wird und sich auf das Zeitbereichssignal des OFDM-Übertragungssystems bezieht. Die inverse schnelle Fourier-Transformation (IFFT = Inverse Fast Fourier Transformation) generiert ein diskretes Zeitsignal, das NT-Abtastwerte aufweist und in Gleichung 6 der Fig. 11 angegeben ist. N bezeichnet die Anzahl der Träger des OFDM-Systems und T gibt den Überabtastfaktor für die Bestimmung des PAPR an, vgl. auch S. H. Han and J.H. Lee, "An overview of peak-to-average power ratio reduction techniques for multicarrier transmission", IEEE Wireless Commun, Bd. 12, Nr. 2, S. 56-65, 2005.

Zwei Parameter können in Ausführungsbeispielen für jede der S Schichten berechnet werden, nämlich das Modulationsformat und der Leistungsskalierungskoeffizient. Werden alle möglichen Kombinationen der S Schichten und M Modulationsformate verglichen, erhält man eine asymptotische Komplexität von $O(M^s)$. Im betrachteten Ausführungsbeispiel weisen die drei Schichten 160, 200 und 200 kBit/s auf.

Im Folgenden wird der Einfachheit halber angenommen, dass in dem Ausführungsbeispiel 660 Bits, d.h. 160 für Schicht 1 und jeweils 200 für die Schichten 2 und 3, in einem TTI übertragen werden in einem 256-Träger-System. Zwischen den einzelnen Schichten soll ein Signalrauschabstandsunterschied von 8 dB garantiert sein, um die Dynamik der Kanal- und Leistungsskalierungsfaktoren abzufangen, und somit die PAPR gering zu halten. Ferner werden im Folgenden vier Modulationsalphabete berücksichtigt, nämlich BPSK, QPSK, 16-QAM und 64-QAM. In einem uncodierten OFDM-System braucht QPSK ein um etwa 3 dB verbessertes Signalrauschverhältnis im Vergleich zu einem BPSK-System, um mit der gleichen Bitfehlerrate decodiert zu werden. 16 QAM benötigt etwa 6 dB und 64-QAM benötigt etwa 5,2 dB gegenüber BPSK. Wenn man diese $4^3$=64 Kom-

binationen vergleicht, so ergibt sich für dieses Ausführungsbeispiel, dass BPSK in der Schicht 1, 16-QAM in der Schicht 2 und 64-QAM in der Schicht 3 gut anwendbar ist. Um die erwünschte 8 dB Unterschied zu erreichen, ergeben sich Leistungsskalierungsfaktoren für die Schicht 1 von 1, für die Schicht 2 von 1,25 und für die Schicht von 0,66.

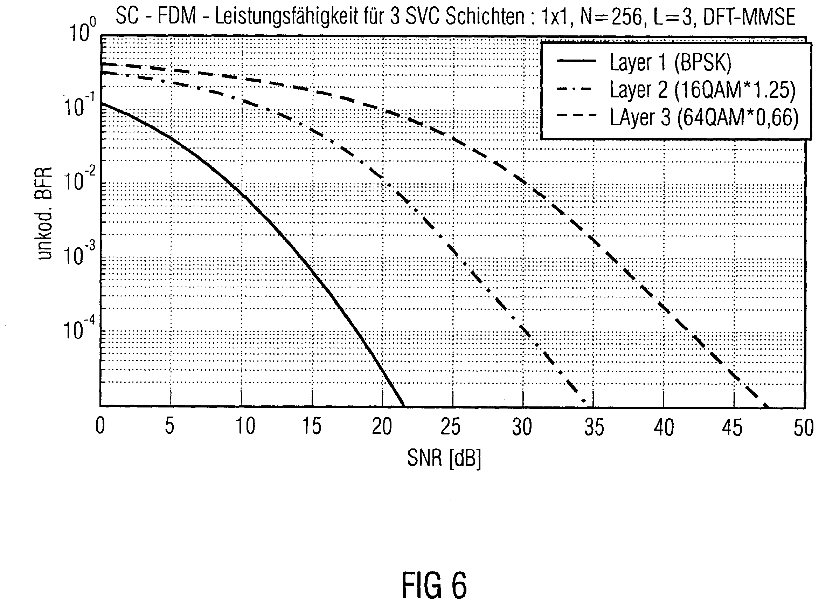

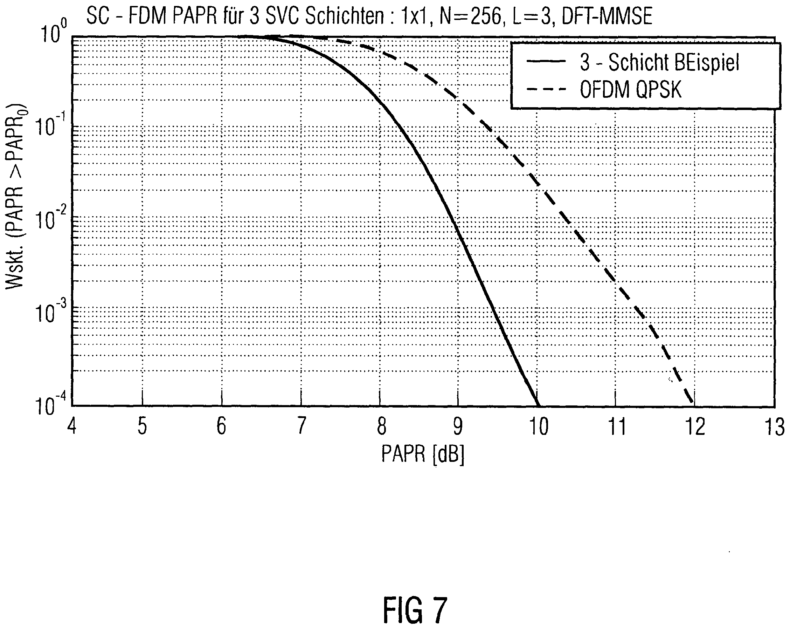

Die Fig. 6 zeigt Simulationsergebnisse für das oben betrachtete Ausführungsbeispiel in einem Rayleigh-Funkkanal mit L=3 unabhängigen Schwundkanälen. Insbesondere ist die uncodierte Bitfehlerrate über das Signalrauschverhältnis aufgetragen. Die Bitfehlerrate der Schicht 1 ist mit einer durchgehenden Linie angegeben, die Bitfehlerrate der Schicht 2 ist mit einer strichpunktierten Linie angegeben und die Bitfehlerrate der Schicht 3 ist mit einer gestrichelten Linie angegeben. Bei der Übertragung wurde eine DFT-Spreizung und eine Frequenzbereichsentzerrung (MMSE) durchgeführt. Bei einer uncodierten Bitfehlerrate von $2x10^{-4}$ lässt sich erkennen, dass die drei Kurven der zwei Schichten einen Unterschied von etwa 12,2 dB zwischen Schicht 1 und Schicht 2 einerseits und 11,5 dB zwischen Schicht 2 und Schicht 3 andererseits aufweisen. In anderen Worten werden durch die beschriebenen Konzepte und durch die Codierung etwa 25 dB des SNR-Bereichs abgedeckt. Durch eine plötzliche Verschlechterung der Signalstärke könnte der Video-Datenstrom demnach nicht abreißen, sondern lediglich seine Qualität verringern. Der zusätzliche Unterschied wird auch durch die DFT-Spreizung hervorgerufen, die ebenfalls die Mehrwegediversität ausnutzt, da die Teilströme auf eine Bandbreite aufgespreizt werden, die größer als die Kohärenzbandbreite des Mobilfunkkanals ist. Ferner wurde bereits oben auf den Zusammenhang zum RAKE-Empfänger hingewiesen. Zusätzlich wird die PAPR reduziert durch die Einträgerübertragung. Dies ist in der Fig. 7 dargestellt. Die Fig. 7 zeigt eine komplementäre Verteilungsfunktion (CCDF = Complementary Cumulative Distribution Function) des PAPR für das betrachtete Dreischichtenausführungsbeispiel, angegeben durch eine durchgezogene Linie, und für ein uncodiertes 256 Träger OFDM-System mit QPSK-Modulation, angegeben durch eine gestrichelten Linie. Wie bereits in S.H. Han and J.H. Lee, "An overview of peak-to-average power ration reduction techniques for multicarrier transmission", IEEE Wireless Commun, Bd. 12, Nr. 2, S. 56-65, 2005, wurde ein Überabtastungsfaktor von T=4 gewählt, um die entsprechenden Werte zu berechnen. Die 0,1% PAPR-Grenze von SVC liegt bei etwa 9,5 dB, wohingegen die OFDM-QPSK-Referenz etwa bei 11,3 dB liegt. Das vorgeschlagene Ausführungsbeispiel nutzt demnach nicht nur die Vorteile der Mehrwegediversität aus, sondern erzielt auch eine bessere PAPR-Verteilung aufgrund des eingesetzten SC-FDM-Konzepts.

Im Folgenden werden Systemlevel-Simulationsergebnisse dargelegt. Um realistische Teilnehmerkanäle in einem Mehrzellenvielfach-Zugriffsszenario zu erhalten, wurden Systemlevelsimulationen basierend auf dem 3GPP- (3GPP = Third Generation Partnership Project) Raumkanalmodell (vgl. 3GPP TR 25.996 v7.0.0, "Spatial channel model for multiple input multiple output (MIMO) simulations", Tech. Rep. 6, 2007) durchgeführt. Zusätzlich zur Originalversion wurden verschiedene Erweiterungen, wie beispielsweise die Unterstützung für polarisierte Antennen (vgl. L. Jiang, L. Thiele, and V. Jungnickel, "On the modelling of polarized MIMO Channel", Proc. European Wireless Conference ,07, 2007) Antennenneigung, sogenannter Antennentilt, und vermischte Szenarien (vgl. L. Thiele, M. Schellmann, W. Zirwas, and V. Jungnickel, "Capacity scaling of multiuser MIMO with limited feedback in a multicell environment", Proc. Asilomar , 07, 2007) berücksichtigt, um realistische Statistiken zu erhalten.

Als Kanalmodell wurde das SCME-C (SCM = Spatial Channel Model, E-C = urbanes makrozellulares Szenario) bei einer Mittenfrequenz von 2 GHz betrachtet. Die Bandbreite beträgt 30,72 MHz mit einer Anzahl von 512 Unterträgern und 7 Basisstationstandorten, wobei von jedem Basisstationsstandort aus 3 Sektoren versorgt wurden. Die Basisstationshöhe wurde zu 32m angenommen, die Mobilstationshöhe zu 2m. Ferner wurde davon ausgegangen, dass sich die Basisstationen in einem Abstand von 1000m zueinander befinden, und dass Antennen mit einem Antennengewinn von 14dBi in kreuzpolarisierter Form vorhanden sind. Der Neigungswinkel der Antennen wurde zu 3,7° angenommen sowie eine maximale Sendeleistung pro Basisstation von 30dBm. Ferner ging man von einer Eingangsempfindlichkeit des Empfängers von -95dBm aus.

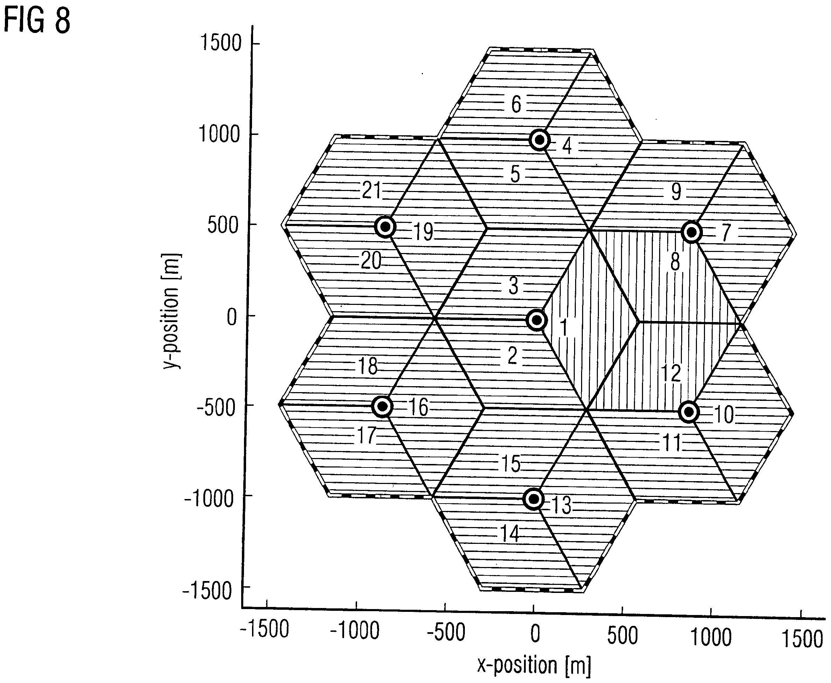

Die SCME-Simulationsumgebung sieht vor, dass 10.000 Teilnehmer zufällig zwischen die drei Basisstationen gesetzt werden, die in der Fig. 8 dargestellt sind. Fig. 8 zeigt ein zellulares Netzwerkszenario, wie es bereits anhand der Fig. 4 erklärt wurde. Die drei dunkel unterlegten Bereiche in der Fig. 8 zeigen den Bereich des Netzwerkes an, in dem die Teilnehmerkanäle ausgewertet wurden. Es wird ferner davon ausgegangen, dass eine 2x2 polarisierte Kanalrealisierung **H** für jeden Teilnehmer berechnet wird. Die SCM-Kanalkoeffizienten können dann benutzt werden, um eine Bitfehlerratensimulation für das Dreischichten-SVC-Ausführungsbeispiel zu berechnen. Die simulierte Übertragungskette benutzt exemplarisch 512 OFDM-Träger. 320 Ressourcen werden der Schicht 1 zugeordnet mit BPSK-Modulation. Schicht 2 verfügt über 100 Ressourcen mit 16 QAM und einem Leistungsskalierungsfaktor von 1,25. Schicht 3 verfügt über 68 Ressourcen mit einem Multiplikator von 0,66. Der Kanal **H** wird als konstant angenommen über einen Zeitraum von 50 Realisierungen, wobei sich das überlagerte Rauschen von Realisierung zu Realisierung ändert.

Für das Hintergrundrauschen wurde eine Leistung von -95dBm angenommen, und die Gesamtsendeleistung einer Basisstation beträgt 30dBm. Die vergleichsweise geringe Leistung stellt sicher, dass keines der betrachteten Übertragungskonzepte eine 100%ige Abdeckung erreicht, um einen fairen Vergleich der Ergebnisse zu ermöglichen. Insgesamt werden 66.000 zufällige Bits übertragen. Für diese Bits werden die Bitfehlerraten für alle SVC-Schichten ausgewertet. Wenn eine Bitfehlerrate erreicht wird, die geringer als $2x10^{-4}$ ist, wird davon ausgegangen, dass die jeweilige Schicht fehlerfrei ist. In den betrachteten Simulationen wird kein zusätzlicher Kanalcode benutzt.

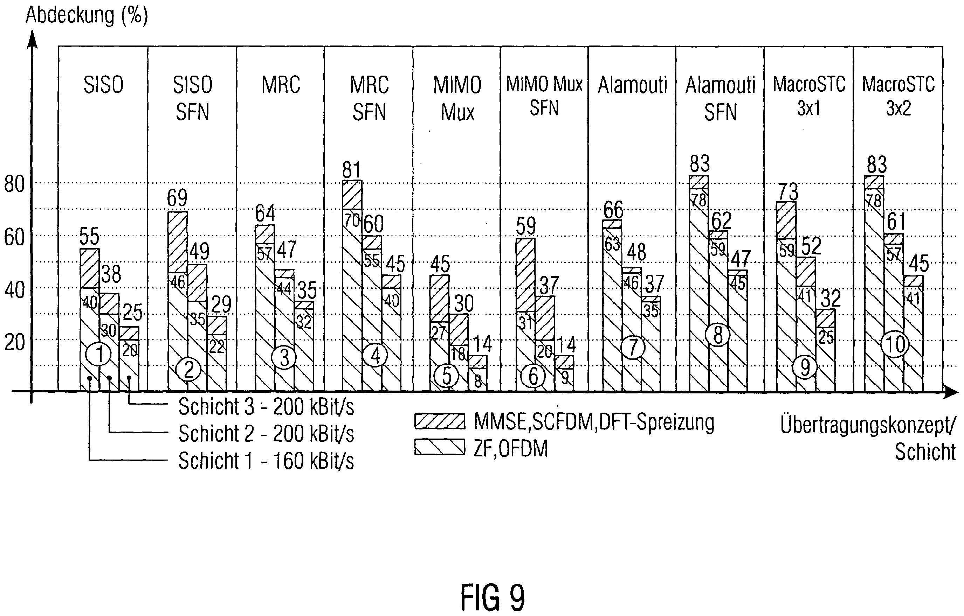

Fig. 9 illustriert die erzeugten Simulationsergebnisse. In der Fig. 9 sind auf der x-Achse verschiedene Übertragungskonzepte für die einzelnen Schichten in Form von Balkendiagrammen aufgetragen, wobei die Höhe der einzelnen Balken die relative Abdeckung in Prozent angibt. In jedem Balkendiagramm ist durch einen hellgrauen Abschnitt die Abdeckung für MMSE, SCFDM mit DFT-Spreizung angegeben, in dem dunklen Bereich ein Referenzsystem ZF,OFDM (ZF = Zero Forcing). Als Übertragungskonzepte wurden SISO (SISO = Single Input Single Output), d.h. ein System mit einer Sende- und einer Empfangsantenne berücksichtigt, SISO SFN, MRC, MRC-SFN, MIMO Mux, MIMO Mux SFN, Alamouti, Alamouti SFN, Makro STC 3x1 und Makro STC 3x2.

Aus den gegenübergestellten Übertragungssystemen lässt sich ableiten, dass MMSE-DFT-SCFDM ZF-OFDM immer überragt. Diese Gewinne verringern sich jedoch mit zunehmender räumlicher Diversität, wie sich beispielsweise an den Fällen MRC, Alamouti, Alamouti-SFN und MakroSTC 3x2 gezeigt hat. Der Übersichtlichkeit halber sind die betrachteten Übertragungskonzepte von links nach rechts in der Fig. 9 der Reihe nach durchnummeriert. Die Reduzierung der Gewinne ist auf die Tatsache zurückzuführen, dass ZF-OFDM nicht in der Lage ist, Frequenzdiversität auszunutzen. Wenn die Antennendiversität oder die räumliche Diversität (MRC oder STC) genutzt wird, erhöht sich auch die entsprechende Abdeckung für ZF-OFDM.

In der Fig. 9 lässt sich ferner erkennen, dass SFN-Übertragung die Abdeckung für alle Übertragungskonzepte steigert. Im Falle von SFN kann die Empfangsleistung am Zellrand durch Kombination der zusätzlichen Echos erhöht werden. Die DFT-MMSE Frequenzbereichsentzerrung ist in der Lage, diese Echos konstruktiv zu überlagern, wohingegen ZF-OFDM lediglich den Gewinn des Feldes ausnutzt, nicht jedoch den Diversitätsgewinn. Ferner lässt sich der Fig. 9 entnehmen, dass die betrachteten Makrodiversitätskonzepte keine substantiellen Gewinne erreichen. In den Fällen 9 und 10 wurde eine orthogonale 3x1 STC verwendet (vgl. B. Hassibi and B.M. Hochwald, "High-rate codes that are linear in space and time", IEEE Trans. Inf. Theory, Bd. 48, Nr. 7, S. 1804-1824, 2002). Im zweiten Fall SISO-SFN, und im neunten Fall, 3x1 STC, werden die gleichen Antennenkonstellationen, d.h. drei Sendeantennen an den drei Sendern und eine Empfangsantenne am Empfänger, verwendet. Der Unterschied ist, dass im Fall 9 Diversität in der Raumebene ausgenutzt wird, wohingegen im Fall 2 die zusätzlichen Sendesignale im Frequenzbereich korreliert werden, wodurch Frequenzdiversität ausgenutzt wird.

Die Fälle 10, 3x2 STC, und 4, SIMO-SFN-MRC, weisen ebenfalls die gleiche Antennenkonstellation mit drei Sendeantennen an jeweils drei Basisstationen und zwei Empfangsantennen an der Mobilstation auf. Das Makrodiversitätskonzept liefert eine größere Reichweite als das SFN-Schema nur für ZF-OFDM-Systeme. Dies resultiert aus der Tatsache, dass ZF keine Frequenzdiversität ausnutzt. Wenn jedoch Frequenzdiversität durch DFT-Spreizung und MMSE-Entzerrung ausgenutzt wird, liegt der erzielbare Gewinn durch Makrodiversität nur noch in einem Bereich von 1-4%. Betrachtet man zusätzlich, dass beispielsweise eine 3x1 STC nur 3/4 der Datenrate erreicht und das keine orthogonale Vollraten-STC für mehr als zwei Antennen existiert, liegt die Vermutung nahe, dass Makrodiversität nicht in allen Fällen Gewinne erzielt.

Den Simulationsresultaten nach zu urteilen sind zwei Ausführungsbeispiele besonders geeignet für Rundfunksysteme. In einem Ausführungsbeispiel wird Alamouti STC mit SFN-Übertragung mit zwei Sendeantennen pro Basisstation und zwei Empfangsantennen an der Empfangsstation verwendet. Diese Konfiguration erreicht auch mit der reduzierten Sendeleistung von nur 1 Watt die beste Abdeckung. 83% der Teilnehmer können die Schicht1-Daten decodieren, 47% aller Teilnehmer können alle drei Teilströme oder Schichten decodieren. Wird zu einem MIMO-Multiplexkonzept mit SFN umgeschaltet (Fall 6 in Fig. 9), können zwei Teilströme gleichzeitig übertragen werden. Dies erhöht die Datenrate um einen Faktor von 2, ist aber mit substantiellen Reichweiteverlusten verbunden.

Mit 46dBm, 40W Sendeleistung können Reichweiten erzielt werden, bei denen 99,8% der Teilnehmer die Schicht-1-Daten, 95% der Teilnehmer die Schicht-1- und -2-Daten und 79% aller Teilnehmer die Daten aller drei Schichten empfangen können, wenn auf das Alamouti-Konzept mit SFN zurückgegriffen wird. Bei gleicher Sendekonfiguration mit räumlichem Multiplex können 94% die Daten der Schicht 1, 68% die Daten der Schichten 1 und 2, und 49% die Daten der Schichten 1 bis 3 empfangen. Es bleibt zu erwarten, dass diese Werte sich weiter verbessern werden, wenn der Abstand zwischen den Basisstationen geringer wird. Daher erscheint das Ausführungsbeispiel mit MIMO-Multiplex eine Option für kleinere Zellen, beispielsweise im Indoor-Bereich.

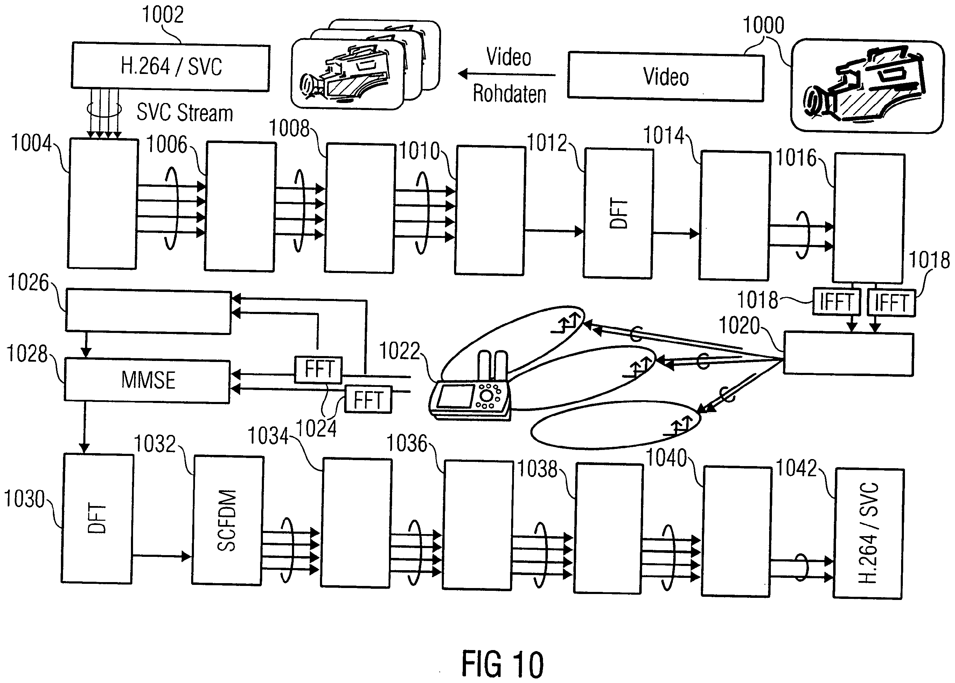

Im Folgenden sollen Ausführungsbeispiele noch einmal anschaulich anhand der Fig. 10 erläutert werden, die ein Überblick-Blockschaltbild für ein Systemkonzept zeigt. Die Fig. 10 zeigt eine Signalverarbeitungskette eines ganzen Übertragungssystems, das sich aus einem Sender und einem Empfänger zusammensetzt, wobei die Komponenten des Senders in der oberen Hälfte der Fig. 10 dargestellt sind, und die Komponenten des Empfängers in der unteren Hälfte. Das im Folgenden beschriebene Ausführungsbeispiel weist eine Kombination aus DFT-Spreizung, Space-Time-Coding und Single-Carrier-Übertragung auf, um im Vergleich zu konventionellen Rundfunksystemen zusätzliche Diversitätsgewinne zu erhalten.

In anderen Worten können Ausführungsbeispiele eine Frequenzspreizung bzw. einen Frequenzspreizer aufweisen, um Übertragungssymbole des ersten und zweiten Teilstroms in einem Frequenzbereich zu überlagern. Ferner können Ausführungsbeispiele einen Raum-Zeit-Codierer aufweisen, um die überlagerten Übertragungssymbole zu codieren. Ferner kann in Ausführungsbeispielen ein OFDM-Sender verwendet werden, um die überlagerten Übertragungssymbole über einen Funkkanal als Übertragungskanal zu übertragen. In Ausführungsbeispielen kann der OFDM-Sender eine Anzahl von Unterträgern aufweisen, die sich von der Dimension des Frequenzspreizers unterscheidet. Beispielsweise ist es in Ausführungsbeispielen denkbar, die Bandbreite des OFDM-Senders größer zu wählen als die Bandbreite des Ausgangssignals des Frequenzspreizers. In solchen Ausführungsbeispielen ergeben sich mehrere Möglichkeiten, wie das Ausgangssignal des Frequenzspreizers auf die Unterträger des OFDM-Senders abgebildet werden kann. Beispielsweise kann eine Abbildung blockweise erfolgen, wobei das Ausgangssignal dann unverändert einem Block von Unterträgern des OFDM-Senders zugewiesen werden kann, der sich am oberen oder unteren Ende des OFDM-Frequenzbereichs befinden kann, jedoch auch einem mittleren Bereich zugeordnet werden kann. In anderen Ausführungsbeispielen ist auch eine kammartige Zuweisung möglich, bei der die Komponenten des Ausgangssignals einem Kamm von Unterträgern des OFDM-Frequenzbereichs zugewiesen werden können, d.h. dass die zugewiesenen OFDM-Unterträger nicht lückenlos nebeneinander liegen, sondern auch unbesetzte Unterträger dazwischen liegen können.

In analoger Weise können Ausführungsbeispiele einen OFDM-Empfänger aufweisen. Dem OFDM-Empfänger kann ein Frequenzentspreizer nachgeschaltet sein, um in der Frequenz gespreizte Empfangssymbole zu entspreizen. Die Dimension des Frequenzentspreizers kann dabei kleiner sein als eine Anzahl von Unterträgern des OFDM-Empfängers.

In weiteren Ausführungsbeispielen können die Komponenten des Ausgangssignals des Frequenzspreizers mehreren Teilblöcken von Unterträgern des OFDM-Systems zugewiesen werden. Dabei können die durch die Komponenten des Ausgangssignals belegten Unterträger lückenhaft belegt sein, d.h. einzelne oder mehrere Unterträger können in einem Block der von den Komponenten belegten Unterträger nicht besetzt oder durch andere Signale belegt sein. Diese Unterträger bieten die Möglichkeit zur Übertragung anderer Signale, ebenfalls unter Ausnutzung von Frequenzdiversität. Diese anderen Signale können beispielsweise Steuersignale sein, mit denen Systeminformationen, Paginginformationen, Kontrollinstruktionen usw. übertragen werden. In Ausführungsbeispielen können diese Unterträger beispielsweise dazu verwendet werden, Pilotsymbole zu übertragen. Dabei ist es ein Vorteil von Ausführungsbeispielen, dass die einzelnen Unterträger derart gewählt werden können, dass über diese Pilot- oder Referenzsymbole übertragen und eine Frequenzdiversität ausgenutzt werden kann. In anderen Worten können die Komponenten im Frequenzbereich, d.h. über die zur Verfügung stehenden OFDM-Träger des Systems verteilt werden und so Frequenzdiversität ausnutzen. Darüber hinaus können auch Pilotsymbole und andere Systeminformationen über den Frequenzbereich aufgespreizt werden, so dass auch bezüglich der Systeminformationen und Steuersignale ein Spreizgewinn ausgenutzt werden kann.

Ausführungsbeispiele, die derartig im Frequenzbereich verteilte Pilotsymbole benutzen, können beispielsweise eine Kanalschätzung im Frequenzbereich ermöglichen. In anderen Worten können in einem Ausführungsbeispiel die mit Pilot- oder Referenzsymbolen belegten Unterträger derart gewählt werden, dass deren Abstand im Frequenzbereich die Kohärenzbandbreite des Funkkanals nicht überschreitet. Dies führt dazu, dass in solchen Ausführungsbeispielen die Pilotsymbole im Frequenzbereich als Stützstellen des Kanals verwendet werden können, und eine Interpolation zwischen den daraus resultierenden Kanalschätzungen im Frequenzbereich durchgeführt werden kann. Ist in Ausführungsbeispielen der Kanal im Frequenzbereich geschätzt worden, können nunmehr auch die zugehörigen Daten im Frequenzbereich entzerrt werden. Dies bietet entscheidende Vorteile bei der sich der Kanalschätzung anschließenden Signalverarbeitung, da die Entzerrung im Frequenzbereich mit weniger Aufwand zu bewerkstelligen ist als im Zeitbereich. In einem Ausführungsbeispiel kann eine einfache Entzerrung im Frequenzbereich dadurch erreicht werden, dass mit einer inversen Kanalschätzmatrix, bzw. mit einer inversen Übertragungsmatrix, multipliziert wird.

Ausführungsbeispiele bieten somit den Vorteil, dass diese aufgrund der Verwendung eines OFDMA-Systems zusammen mit der Frequenzspreizung der Komponenten des Ausgangssignals der Frequenzspreizers dazu verwendet werden können, eine Frequenzbereichsentzerrung zu ermöglichen. Gerade im Falle des Rundfunkszenarios ist dies erstrebenswert, da die Frequenzbereichsentzerrung weniger aufwendig ist, und zumeist auf Mobilteilen implementiert ist, die weniger Rechen- und Leistungsressourcen bieten. Damit kann eine effizientere Signalverarbeitung bzw. eine erhöhte Übertragungsqualität ermöglicht werden.

Gegenüber herkömmlichen Frequenzspreizsystemen, bieten Ausführungsbeispiele den Vorteil, dass einzelne Unterträger z.B. mit Pilot- oder Referenzsymbolen oder anderen Signalen bzw. Symbolen belegt werden können. Dadurch sind verschiedene Zuordnungen von Daten und Piloten und anderen Steuerkanälen zu den Unterträgern des OFDMA-Systems denkbar, wie bereits oben beschrieben. Herkömmliche Systeme erlauben zumeist keine Frequenzbereichsentzerrung, da dort alle Signale über den gleichen Frequenzbereich, d.h.

über die gleiche Bandbreite aufgespreizt werden. Diese Signale können also im Frequenzbereich nicht voneinander isoliert werden, da sich diese dort überlagern. Erst eine entsprechende Spreizung, die gerade Lücken für Pilotsymbole lässt, ermöglicht die Schätzung und Entzerrung im Frequenzbereich.

Ausführungsbeispiele bieten ferner den Vorteil, dass sich ein Synergieeffekt zwischen der Frequenzspreizung von Rundfunkdaten und der Kanalschätzung, bzw. Entzerrung, im Frequenzbereich ergibt. Durch das Ausnutzen der Frequenzdiversität können, wie bereits oben beschrieben, beispielsweise Leistungsverhältnisse, die zwischen den einzelnen Teilströmen eingestellt werden, stabil gehalten werden. Die sich anschließende Signalverarbeitung im Frequenzbereich erlaubt ein effektives Ausnutzen von Frequenzdiversität bereits im Frequenzbereich, so dass sich auch insgesamt eine robustere Übertragung, damit einhergehend eine höhere Systemkapazität bzw. Systemstabilität und Reichweite ergeben kann.

In Ausführungsbeispielen kann der Empfänger folglich einen Kanalschätzer aufweisen, um einen OFDM-Übertragungskanal im Frequenzbereich zu schätzen.

In Ausführungsbeispielen lässt sich generell über die Wahl der Übertragungstechniken, beispielsweise MIMO-Multiplex oder STC, unterschiedliche SFN-Zellen, usw. die Größe des zu versorgenden Gebietes und der Durchsatz skalieren. Die wesentlichen Punkte des Verfahrens sollen anhand der Fig. 10 nochmals erläutert werden. Die Fig. 10 zeigt eine Videoquelle 1000, die Videodaten einem Videocodierer 1002 zuführt, der beispielsweise als H.264/SVC-Codierer realisiert sein kann. Am Ausgang des Videocodierers 1002 liegen dann beispielsweise die einzelnen Teilströme des SVC-Mediadatenstromes an, die nachfolgend im Block 1004 im Rahmen einer Vorwärtsfehlerkorrektur codiert bzw. mit Redundanzen versehen werden können. Anders ausgedrückt wird den unterschiedlichen Teilströmen durch den Block unterschiedliche Redundanz hinzugefügt. Am Ausgang des Codieres 1004 liegen dann binäre Datenströme vor. Die einzelnen Schichten des SVC-Videostromes werden dann mit unterschiedlichen IQ-Modulationen im IQ-Modulator 1006 voneinander getrennt, indem der IQ-Modulator 1006 beispielsweise Symbole, wie z.B. einzelne oder eine Gruppe aufeinanderfolgender Bits, der Teilströme bijektiv auf Konstellationspunkte des dem jeweiligen Teilstrom zugeordneten Modulationsverfahrens abbildet, wobei die Modulationsverfahren wie im vorhergehenden erwähnt geeignet ausgewählt sind, so dass der IQ-Modulator dafür sorgen kann, dass sich bei gleichem SNR am Empfänger unterschiedliche Bitfehlerraten für die einzelnen Ströme ergeben. Am Ausgang des Modulators 1006 liegen dann Symbolströme, nämlich einer für jeden Teilstrom, vor, die im Leistungsskalierer 1008 wie im vorhergehenden beschrieben leistungsskaliert werden können. Am Ausgang des Leistungsskalierers 1008 liegen dann leistungsskalierte Symbolströme vor. Ausführungsbeispiele bieten somit den Vorteil, dass durch zusätzliches Skalieren der Sendeleistung für die einzelnen Teilströme eine präzise Einstellung der gewünschten minimalen Bitfehlerrate für jeden Layer am Empfänger möglich wird.

Die skalierten Symbolströme werden einem SC-FDM-Zuweiser 1010 zugeführt, der die einzelnen Symbole der Teilströme demultiplext, um diese dem DFT-Spreizer 1012 zuzuführen. Ausführungsbeispiele bieten den Vorteil, dass durch die DFT-Spreizung im Rundfunkkanal der Abwärtsstrecke eines Mobilfunksystems, die Mehrwege- und SFN-Diversität ausgenutzt werden kann.

Ausführungsbeispiele bieten ferner den Vorteil, dass die Wahl des Modulationsverfahrens und der Leistungsskalierung von der aktuellen Bitrate des jeweiligen SVC-Layers oder der SVC-Schicht abhängig gemacht werden kann. Die Eingänge der DFT 1012, d.h. die verfügbaren Ressourcen, können so adaptiv an die einzelnen Ströme vergeben werden, beispielsweise durch Zuweisungsverfahren. Man spricht auch von Scheduling. Für das Videosignal bedeutet dies in Ausführungsbeispielen, dass sowohl variable Bitraten für jede Schicht als auch für statistisches Multiplexing unterstützt werden können.

In anderen Worten kann die Vorrichtung zum Zuweisen in Ausführungsbeispielen ferner eine Einrichtung zum Zuweisen von Funkressourcen aufweisen. In Ausführungsbeispielen kann die Einrichtung zum Zuweisen von Funkressourcen angepasst sein, um Funkressourcen zu den ersten Übertragungssymbolen und den zweiten Übertragungssymbolen zuzuweisen, um variable Datenraten des ersten Teilstroms und des zweiten Teilstroms auszugleichen.

Die Einrichtung zum Zuordnen von Funkressourcen, die im Folgenden auch Scheduler genannt werden kann, ordnet dabei Funkressourcen den Übertragungssymbolen zu, die zuvor den entsprechenden Informationssymbolen der Teildatenströme, d.h. des ersten Teilstromes und des zweiten Teilstromes, zugeordnet wurden.

Unter Funkressourcen seien an dieser Stelle sämtliche Funkressourcen verstanden, wie beispielsweise eine oder mehrere Funkressourcen aus der Gruppe von Frequenzen, Unterträgern, Zeitschlitzen, Spreizsequenzen, Codes, räumlicher Unterkanäle, Richtungen, Frequenzen, Antennen, Hopping-Sequenzen, Interleaversequenzen, Leistungen usw. In Ausführungsbeispielen kann demnach ein Scheduler die Zuordnung von Funkressourcen zu den eigentlichen Übertragungssymbolen schnell anpassen oder vornehmen, wobei auf eine Frequenzspreizung nicht verzichtet werden muss.

In einem einfachen Ausführungsbeispiel können beispielsweise unterschiedliche Anzahlen von Unterträgern zu den Übertragunssymbolen der Teildatenströme zugeordnet werden, wobei hierbei nicht auf eine Verschachtelung bzw. Aufweitung im Frequenzbereich verzichtet werden muss. Die Zuordnung der Unterträger und die damit mögliche Aufspreizung im Frequenzbereich kann dabei aufwandsgünstig mit der Zuordnung anderer Funkressourcen kombiniert werden. In einfachen Ausführungsbeispielen, könnten beispielsweise den Übertragungssymbolen des ersten Teilstromes jeder fünfte Unterträger eines OFDMA-Systems zugeordnet werden. Steigt nun die Datenrate im ersten Teilstrom an, d.h. werden mehr Übertragungs- oder Funkressourcen benötigt, so könnten den nun mit höherer Rate zugeordneten Übertragungssymbolen des ersten Teilstroms beispielsweise jeder vierte Unterträger des OFDMA-Systems zugeordnet werden.

In analoger Weise können in Ausführungsbeispielen auch Unterträger zwischen den beiden Teilströmen aufgeteilt werden. In anderen Worten können Ausführungsbeispiele die Anzahl der zugeordneten Unterträger eines OFDMA-Systems zwischen den Teilströmen hin- und herschichten.

In einfachen Ausführungsbeispielen wäre es denkbar, den ersten Übertragungssymbolen beispielsweise zwei Drittel einer Anzahl von Unterträgern zuzuordnen, wohingegen den zweiten Übertragungssymbolen lediglich ein Drittel der Unterträger zugeordnet werden. Dies könnte in einem Ausführungsbeispiel erlauben, dass bezüglich des ersten Teilstroms mehr Redundanz übertragen werden kann, die am Empfänger entsprechend ausgewertet werden kann, so dass sich für die ersten Übertragungssymbole der oben erwähnte Kanal mit der geringeren Fehlerwahrscheinlichkeit ergibt.

Ausführungsbeispiele können somit eine vorteilhafte Adaption der Zuordnung von Funkressourcen zu den ersten und zweiten Übertragungssymbolen erlauben. Dadurch können Funkressourcen, insbesondere Unterträger eines OFDMA-Systems, effizienter eingesetzt werden, beispielsweise kann eine Kanalschätzung im Frequenzbereich ermöglicht werden. Insgesamt kann sich durch die variable Zuordnung ein robusteres System, eine höhere Übertragungsqualität und/oder eine größere Reichweite ergeben.

Ausführungsbeispiele bieten ferner den Vorteil, dass die größte der DFT an die gesamte verfügbare Bandbreite angepasst werden kann. Die Eingänge des DFT-Coders oder - Spreizers 1012 können als primäre Ressourcen für die adaptive Aufteilung der SVC-Videoströme verwendet werden. Als resultierende Wellenform ergibt sich dann ein aus mehreren Wellenformen zusammengesetztes Einträgersignal. Man spricht auch von Single-Carrier-Signal.

Gemäß der Fig. 10 wird das so gewonnene Signal mittels eines Raum-Zeit-Codierers 1014, der beispielsweise das Alamouti-Konzept realisiert, auf verschiedene Antennen einer Basisstation aufgezeigt. Zuvor werden noch von einer Piloteinheit 1016 Pilotsymbole, die dann am Empfänger die Kanalschätzung ermöglichen, in das Signal eingefügt. Die Fig. 10 zeigt ferner, dass die Raum-Zeit-codierten Ausgangssignale mit den Pilotsymbolen in zwei IFFT 1018 in den Zeitbereich transformiert werden, wo sie dann über einen SFN-Verteiler 1020 an die einzelnen Basisstationen verteilt werden.

Ausführungsbeispiele bieten ferner den Vorteil, dass neben der Raum-Zeit-Codierung kreuzpolarisierte Antennen zusätzliche Diversitätsgewinne ermöglichen können. Alternativ können beispielsweise für kleinere Zellen auch Raum-Zeit-Multiplex verwendet werden. Dabei können dann verschiedene räumliche Ströme erzeugt werden, wobei sich der Durchsatz erhöht, die Größe der versorgten Fläche, d.h. die Reichweite, jedoch sinkt.

Der SFN-Verteiler 1020 der Fig. 4 synchronisiert benachbarte Basisstationen in einem Gleichwellennetz, so dass diese synchronisierte gleiche Signale abstrahlen.

Die Pilotsignale im Frequenzbereich können in Ausführungsbeispielen dem Empfänger ermöglichen, den Kanal zu schätzen. Ein beigefügtes Guard-Intervall verhindert Intersymbolinterferenz. Man spricht auch von einem sogenannten Cyclic Prefix.

Die Signale werden dann von einem Mobilfunkempfänger 1022 empfangen. Zunächst werden die Signale über die beiden FFTs 1024 in den Frequenzbereich transformiert. Im Frequenzbereich können Pilotsymbole extrahiert werden und einem Kanalschätzer 1026 zugeführt werden. Basierend auf dem Ausgang des Kanalschätzers 1026 kann ein Frequenzbereichsentzerrer 1028, beispielsweise auf einer MMSE-Regel basierend, die Daten entzerren. Dem MMSE-Entzerrer 1028 ist ein DFT-Entspreizer 1030 nachgeschaltet, der auch als inverser DFT realisiert sein kann, der das entzerrte Signal in den Zeitbereich transformiert. Die einzelnen Ströme können so in einem SCFDM-Multiplexer 1032 wieder voneinander getrennt werden. An den Teilströmen von Übertragungssymbolen kann nun eine inverse Leistungsskalierung 1034 durchgeführt werden, die von einem IQ-Demodulator 1036 gefolgt wird. Es ergeben sich dann binäre Signale. Die binären Signale können über einen Kanaldecodierer und Detektor bzw. durch eine Fehlerkorrektur 1038 korrigiert werden. Den decodierten Binärströmen kann dann ein CRC-basierter Ratenanpasser 1040 nachgeschaltet sein, der über eine eingefügte CRC-Prüfsequenz (CRC = Cyclic Redundancy Check) ermöglicht, eine Detektion von Fehlern in den einzelnen Layern durchzuführen.

Fehlerhafte höhere SVC-Schichten werden dann verworfen. Fehlerfreie niedrige Layer werden decodiert und das Video kann mit einer reduzierten Qualität ausgegeben werden bzw. in einem Decoder 1042 decodiert werden.

Ausführungsbeispiele der vorliegenden Erfindung bieten somit den Vorteil, dass eine Adaption an den Kanal im Empfänger erfolgen kann. Sinkt die Kanalgüte, steigt die Fehlerrate in den höheren Schichten. Werden diese verworfen, passt sich so die Empfangsqualität automatisch der Kanalgüte an.

Link- und Systemlevel-Simulationen bestätigen das Potential von Ausführungsbeispielen der vorliegenden Erfindung. Ergebnisse basierend auf einer Linklevel-Simulation in einem 3-Echo-Rayleigh-Kanal und 3SVC-Schicht zeigen die Vorteile von Ausführungsbeispielen deutlich, denn abhängig von einem Signal-Rausch-Verhältnis am Empfänger, kann die Qualität der Wiedergabe eines Medieninhalts gesteigert werden.

Ausführungsbeispiele der vorliegenden Erfindung können beispielsweise in Mobilfunknetzwerken oder in WIMAX und 3GLTE-Netzwerken zum Einsatz kommen. Verschiedene Ausführungsbeispiele kombinieren verschiedene Diversitätskonzepte wie beispielsweise Raum-Zeit-Codierung, DFT-Spreizung und SC-FDM-Abbildungen, um verbesserte Übertragungsqualitäten bzw. zuverlässigere Übertragungen in schnurlosen Multimedia-Rundfunknetzwerken bzw. Szenarien zu ermöglichen.

Es wird darauf hingewiesen, dass abhängig von den Gegebenheiten das erfindungsgemäße Schema auch an Software implementiert sein kann. Die Implementation kann auf einem digitalen Speichermedium insbesondere auf einer Diskette, einer CD, einer DVD, einem Flash-Speicher usw. mit elektronisch auslesbaren Steuersignalen erfolgen, die so mit einem programmierbaren Computersystem zusammenwirken können, dass das entsprechende Verfahren ausgeführt wird. Allgemein besteht die Erfindung somit auch in einem Computerprogrammprodukt mit auf einem maschinenlesbaren Träger gespeicherten Programmcode zur Durchführung des erfindungsgemäßen Verfahrens, wenn das Computerprogrammprodukt auf einem Rechner abläuft. In anderen Worten ausgedrückt, kann die Erfindung somit als ein Computerprogramm mit einem Programmcode zur Durchführung des Verfahrens realisiert werden, wenn das Computerprogrammprodukt auf einem Computer oder Prozessor abläuft.

Obige Ausführungsbeispiele zeigten auch eine Vorrichtung zum Schätzen eines Mediadatenstromes basierend auf einem Strom von Empfangssymbolen, mit einem Demultiplexer 543 zum Aufspalten des Stromes von Empfangssymbolen in wenigstens einen ersten Teilsymbolstrom und einen zweiten Teilsymbolstrom; einem ersten Symbolschätzer zum Zuordnen eines ersten Teilstromes von Informationssymbolen des Mediadatenstromes zu dem ersten Teilsymbolstrom, basierend auf einem ersten Symbolalphabet; und einem zweiten Symbolschätzer zum Zuordnen eines zweiten Teilstromes von Informationssymbolen des Mediadatenstromes zu dem zweiten Teilsymbolstrom, basierend auf einem zweiten Symbolalphabet, wobei der erste Teilstrom eine Darstellung eines Mediainhaltes in einer Basisqualität erlaubt und der zweite Teilstrom zusammen mit dem ersten Teilstrom eine Darstellung des Mediainhaltes in einer verbesserten Qualität erlaubt, wobei der Empfänger ferner einen OFDM-Empfänger 530 aufweist, und der Demultiplexer ausgebildet ist, um im Rahmen des Aufspaltens eine Frequenzentspreizung an den Empfangssymbole durchzuführen. Auch ein Empfänger mit einer solchen Vorrichtung zum Schätzen eines Mediadatenstromes wurde gezeigt. Dabei kann der Empfänger ferner einen Kanal-Decodierer aufweisen, der ausgebildet ist, um für die Teilströme unterschiedliche Decodiervorschrift zu benutzen. Eine Dimension der Frequenzentspreizung kann kleiner als eine Anzahl von Unterträgern des OFDM-Empfängers sein. Zudem kann der Empfänger einen Kanalschätzer aufweisen, um einen OFDM-Übertragungskanal im Frequenzbereich zu schätzen.

**Patentansprüche**

**1.** Ein Sender mit einer Vorrichtung zum Zuweisen von Übertragungssymbolen zu einem Mediadatenstrom von Informationssymbolen, wobei der Mediadatenstrom einen ersten Teilstrom zur Darstellung eines Mediainhaltes in einer Basisqualität und einen zweiten Teilstrom mit Zusatzdaten zur Darstellung des Mediainhaltes zusammen mit dem ersten Teilstrom in einer verbesserten Qualität umfasst, mit folgenden Merkmalen:

einer ersten Einrichtung ($512_1$) zum Zuweisen erster Übertragungssymbole zu den Informationssymbolen des ersten Teilstromes;
einer zweiten Einrichtung ($512_2$) zum Zuweisen zweiter Übertragungssymbole zu den Informationssymbolen des zweiten Teilstromes,
wobei die ersten Übertragungssymbole gegenüber den zweiten Übertragungssymbolen über einen Übertragungskanal mit geringerer Fehlerwahrscheinlichkeit übertragbar sind, indem

die ersten Übertragungssymbole einem m-ären Modulationsalphabet entstammen und die zweiten Übertragungssymbole einem n-ären Modulationsalphabet entstammen, wobei $m < n$ ist und m und n natürliche Zahlen sind,
der Sender ferner einen Kanalcodierer (1004) aufweist, der ausgebildet ist, um dem ersten und/oder dem zweiten Teilstrom Redundanz hinzuzufügen, so dass die hinzugefügte Redundanz für den ersten und zweiten Teilstrom unterschiedlich ist, und/oder
der Sender ferner eine Leistungssteuerung (1008) aufweist, die ausgebildet ist, um den Übertragungssymbolen des ersten und zweiten Teilstromes unterschiedliche Sendeleistung zuzuordnen, indem dieselben mit unterschiedlichen Leistungsfaktoren gewichtet werden;

einem DFT, Diskrete Fourier-Transformation, Spreizer (1012), der ausgebildet ist, um die Übertragungssymbole des ersten und des zweiten Teilstromes mit DFT-Spreizsequenzen einer DFT in einen Frequenzbereich zu transformieren und dann zu addieren, um ein Ausgangssignal zu erhalten; und

einen OFDM-Sender, Orthogonal Frequency Division Multiplexing, (520), der ausgebildet ist, um das Ausgangssignal - überlagert in einem gemeinsamen Frequenzbereich - über einen Funkkanal als Übertragungskanal zu übertragen;

einer Einrichtung zum Zuweisen von Funkressourcen, die angepasst ist, um per Scheduling Funkressourcen in Form von Eingängen der DFT zu den ersten Übertragungssymbolen und den zweiten Übertragungssymbolen zuzuweisen, um variable Datenraten des ersten Teilstroms und des zweiten Teilstroms auszugleichen,

wobei der Sender ausgebildet ist, um die ersten und die zweiten Übertragungssymbole als Rundfunkübertragung zu übertragen.

**2.** Sender gemäß Anspruch 1, der ferner einen Raum-Zeit-Codierer (1014) aufweist, um die Übertragungssymbole im Raum-Zeit-Bereich zu codieren.

**3.** Sender gemäß Anspruch 1 oder 2, bei dem der OFDM-Sender (520) ausgebildet ist, um mit einer Anzahl von Unterträgern zu senden, die sich von einer Dimension des DFT-Spreizers unterscheidet.

**4.** Verfahren zum Zuweisen von Funkressourcen zu Übertragungssymbolen und von Übertragungssymbolen zu einem Mediadatenstrom von Informationssymbolen, wobei der Mediadatenstrom einen ersten Teilstrom zur Darstellung eines Mediainhaltes in einer Basisqualität und einen zweiten Teilstrom mit Zusatzdaten zur Darstellung des Mediainhaltes zusammen mit dem ersten Teilstrom in einer verbesserten Qualität umfasst, mit folgenden Schritten:

Zuweisen erster Übertragungssymbole zu den Informationssymbolen des ersten Teilstromes;

Zuweisen zweiter Übertragungssymbole zu den Informationssymbolen des zweiten Teilstromes, wobei die ersten Übertragungssymbole gegenüber den zweiten Übertragungssymbolen über einen Übertragskanal mit geringerer Fehlerwahrscheinlichkeit übertragbar sind, indem

die ersten Übertragungssymbole einem m-ären Modulationsalphabet entstammen und die zweiten Übertragungssymbole einem n-ären Modulationsalphabet entstammen, wobei m < n ist und m und n natürliche Zahlen sind,

dem ersten und/oder dem zweiten Teilstrom Redundanz hinzugefügt werden, so dass die hinzugefügte Redundanz für den ersten und zweiten Teilstrom unterschiedlich ist, und/oder

den Übertragungssymbolen des ersten und zweiten Teilstromes unterschiedliche Sendeleistung durch Gewichtung mit unterschiedlichen Leistungsfaktoren zugeordnet werden;

Transformieren der Übertragungssymbole des ersten und des zweiten Teilstromes mit DFT-Spreizsequenzen einer DFT in einen Frequenzbereich und Addieren derselben in dem Frequenzbereich, um ein Ausgangssignal zu erhalten;

OFDM-Übertragung, Orthogonal Frequency Division Multiplexing, (520), bei der das Ausgangssignal - überlagert in einem gemeinsamen Frequenzbereich - über einen Funkkanal als Übertragungskanal übertragen wird; und Zuweisen, per Scheduling, von Funkressourcen in Form von Eingängen der DFT zu den ersten Übertragungssymbolen und den zweiten Übertragungssymbolen, um variable Datenraten des ersten Teilstroms und des zweiten Teilstroms auszugleichen;

Übertragen der ersten und zweiten Übertragungssymbole als Rundfunkübertragung.

**5.** Vorrichtung zum Schätzen eines Mediadatenstromes einer Rundfunkübertragung, mit folgenden Merkmalen:

einem OFDM-Empfänger (530), der ausgebildet ist, um ein Empfangssignal - überlagert in einem gemeinsamen Frequenzbereich - über einen Funkkanal als Übertragungskanal zu empfangen;

einem Block (540) zum Durchführen einer DFT-Entspreizung durch eine inverse DFT an dem Empfangssignal, um einen parallelisierten Strom von Symbolen zu erhalten, und Aufspalten des parallelisierten Stromes von Symbolen in wenigstens einen ersten Teilsymbolstrom und einen zweiten Teilsymbolstrom; einem ersten Symbolschätzer zum Zuordnen eines ersten Teilstromes von Informationssymbolen des Mediadatenstromes zu dem ersten Teilsymbolstrom, basierend auf einem ersten Symbolalphabet; und

einem zweiten Symbolschätzer zum Zuordnen eines zweiten Teilstromes von Informationssymbolen des Mediadatenstromes zu dem zweiten Teilsymbolstrom, basierend auf einem zweiten Symbolalphabet, wobei

das erste Symbolalphabet einem m-ären Modulationsalphabet und das zweite Symbolalphabet einem n-ären Modulationsalphabet entspricht, wobei m< n ist und m, n natürliche Zahlen sind, und/oder
dem ersten und/oder dem zweiten Teilstrom Redundanz hinzugefügt ist, so dass die hinzugefügte Redundanz für den ersten und zweiten Teilstrom unterschiedlich ist, und/oder
die Teilsymbolströme mit unterschiedlichen Leistungsfaktoren gewichtet und dadurch unterschiedlichen Sendeleistungen zugeordnet sind,

wobei die Zuweisung von Funkressourcen angepasst ist, um per Scheduling Funkressourcen in Form von Eingängen eines DFT-Spreizers im Sender zu den ersten Übertragungssymbolen und den zweiten Übertragungssymbolen zuzuweisen, um variable Datenraten des ersten Teilstroms und des zweiten Teilstroms auszugleichen,
wobei der erste Teilstrom eine Darstellung eines ainhaltes in einer Basisqualität erlaubt und der zweite Teilstrom zusammen mit dem ersten Teilstrom eine Darstellung des Mediainhaltes in einer verbesserten Qualität erlaubt..

**6.** Vorrichtung oder Sender gemäß einem der Ansprüche 1 bis 3, wobei die Mediadaten encodierte Videodaten sind, und der erste Teilstrom und der zweite Teilstrom unterschiedlichen Schichten der encodierten Videodaten entsprechen.

**7.** Empfänger mit einer Vorrichtung zum Schätzen eines Me-diadatenstromes gemäß Anspruch 5.

**8.** Empfänger gemäß Anspruch 7, der ferner einen Raum-Zeit-Decodierer zum Decodieren des Stromes von Empfangssymbolen aufweist.

**9.** Verfahren zum Schätzen eines Mediadatenstromes einer Rundfunkübertragung, mit folgenden Schritten:

OFDM-Empfang eines Empfangssignals - überlagert in einem gemeinsamen Frequenzbereich - über einen Funkkanal als Übertragungskanal;
Durchführen einer DFT-Entspreizung durch eine inverse DFT an dem Empfangssignal, um einen parallelisierten Strom von Symbolen zu erhalten;
Aufspalten des parallelisierten Stromes von Symbolen in wenigstens einen ersten Teilsymbolstrom und einen zweiten Teilsymbolstrom;
Zuordnen eines ersten Teilstromes von Informationssymbolen des Mediadatenstromes zu dem ersten Teilsymbolstrom, basierend auf einem ersten Symbolalphabet; und
Zuordnen eines zweiten Teilstromes von Informationssymbolen des Mediadatenstromes zu dem zweiten Teilsymbolstrom, basierend auf einem zweiten Symbolalphabet, wobei

das erste Symbolalphabet einem m-ären Modulationsalphabet und das zweite Symbolalphabet einem n-ären Modulationsalphabet entspricht, wobei m< n ist und m, n natürliche Zahlen sind, und/oder
dem ersten und/oder dem zweiten Teilstrom Redundanz hinzugefügt ist, so dass die hinzugefügte Redundanz für den ersten und zweiten Teilstrom unterschiedlich ist, und/oder
die Teilsymbolströme mit unterschiedlichen Leistungsfaktoren gewichtet und dadurch unterschiedlichen Sendeleistungen zugeordnet sind,

die Zuweisung von Funkressourcen angepasst ist, um per Scheduling Funkressourcen in Form von Eingängen eines DFT-Spreizers im Sender zu den ersten Übertragungssymbolen und den zweiten Übertragungssymbolen zuzuweisen, um variable Datenraten des ersten Teilstroms und des zweiten Teilstroms auszugleichen,
wobei der erste Teilstrom eine Darstellung eines Mediainhaltes in einer Basisqualität erlaubt und der zweite Teilstrom zusammen mit dem ersten Teilstrom eine Darstellung des Mediainhaltes in einer verbesserten Qualität erlaubt.

**10.** Computerprogramm mit einem Programmcode zur Durchführung des Verfahrens gemäß Anspruch 4 oder 9, wenn der Programmcode auf einem Computer oder einem Prozessor abläuft.

## Claims

**1.** A transmitter comprising an apparatus for assigning transmission symbols to a media data stream of information symbols, the media data stream comprising a first substream for representing a media content in a basic quality and a second substream comprising additional data for representing the media content, along with the first data stream, in an improved quality, comprising:

a first means ($512_1$) for assigning first transmission symbols to the information symbols of the first substream;
a second means ($512_2$) for assigning second transmission symbols to the information symbols of the second substream,
the first transmission symbols being transmissible, via a transmission channel, with reduced error probability as compared to the second transmission symbols, in that

the first transmission symbols originate from an m.ary modulation alphabet and the second transmission symbols originate from an n.ary modulation alphabet, wherein $m \leq n$ and m and n are natural numbers,
the transmitter further comprises a channel coder (1004) configured to add redundancy to the first and/or the second substream(s) so that the added redundancy is different for the first and second substreams and/or the transmitter further comprises a power controller (1008) configured to associate different transmit powers with the transmission symbols of the first and second substreams, by weighting the same with different power factors;

a DFT, discrete Fourier transform, spreader (1012) configured to transform the transmission symbols of the first and second substreams with DFT spreading sequences of a DFT to a frequency range and to then add them to obtain an output signal; and
an OFDM (orthogonal frequency division multiplexing) transmitter (520) configured to transmit the output signal - superimposed in a shared frequency range - via a radio channel as the transmission channel;
a means for assigning radio resources that are adapted to, via scheduling, assign radio resources in form of inputs of the DFT to the first transmission symbols and to the second transmission symbols, and to balance off variable data rates of the first substream and of the second substream,
the transmitter being configured to transmit the first and second transmission symbols as broadcast transmissions.

2. The transmitter as claimed in claim 1, further comprising a space-time coder (1014) for coding the transmission symbols in the space-time domain.

3. The transmitter as claimed in claim 1 or 2, wherein the OFDM transmitter (520) is configured to transmit using a number of sub-carriers differing from a dimension of the DFT spreader.

4. A method of assigning radio resources to transmission symbols, and transmission symbols to a media data stream of information symbols, the media data stream comprising a first substream for representing a media content in a basic quality and a second substream comprising additional data for representing the media content, along with the first data stream, in an improved quality, comprising:

assigning first transmission symbols to the information symbols of the first substream;
assigning second transmission symbols to the information symbols of the second substream, the first transmission symbols being transmissible, via a transmission channel, with reduced error probability as compared to the second transmission symbols, in that

the first transmission symbols originate from an m.ary modulation alphabet and the second transmission symbols originate from an n.ary modulation alphabet, wherein $m \leq n$, and m and n are natural numbers,
redundancy is added to the first and/or the second substream(s) so that the added redundancy is different for the first and second substreams, and/or
different transmit powers are associated with the transmission symbols of the first and the second substreams by weighting with different power factors;

transforming the transmission symbols of the first and second substreams with DFT spreading sequences of a DFT in a frequency range and adding the same in the frequency range in order to obtain an output signal;
OFDM (orthogonal frequency division multiplexing) transmission (520), wherein the output signal - superimposed in a shared frequency range - is transmitted via a radio channel as the transmission channel; and
assigning, per scheduling, radio resources in form of inputs of the DFT to the first transmission symbols and to the second transmission symbols to balance off variable data rates of the first substream and of the second substream;
transmitting the first and second transmission symbols as broadcast transmission.

5. An apparatus for estimating a media data stream of a broadcast transmission, comprising:

an OFDM receiver (530) configured to receive a receive signal - superimposed in a shared frequency range - via a radio channel as the transmission channel;
a block (540) for performing DFT de-spreading via an inverse DFT on the receive signal so as to obtain a parallelized stream of symbols, and splitting up the parallelized stream of symbols into at least a first symbol substream and a second symbol substream;
a first symbol estimator for associating a first substream of information symbols of the media data stream with the first symbol substream on the basis of a first symbol alphabet; and

a second symbol estimator for associating a second substream of information symbols of the media data stream with the second symbol substream on the basis of a second symbol alphabet, wherein

the first symbol alphabet corresponds to an m.ary modulation alphabet and the second symbol alphabet corresponds to an n.ary modulation alphabet, wherein $m \leq n$ and m, n are natural numbers, and/or
redundancy is added to the first and/or the second substream(s) so that the added redundancy is different for the first and second substreams, and/or
the symbol substreams are weighted with different power factors and are thereby associated with different transmit powers,

wherein the assignment of radio resources is adapted to assign, via scheduling, radio resources in form of inputs of a DFT spreader in the transmitter to the first transmission symbols and to the second transmission symbols, to balance off variable data rates of the first substream and of the second substream;
the first substream allowing a media content to be represented in a basic quality, and the second substream along with the first substream allowing the media content to be represented in an improved quality,

**6.** The apparatus or transmitter as claimed in one of claims 1 to 3, wherein the media data are encoded video data, and the first substream and the second substream correspond to different layers of the encoded video data.

**7.** A receiver comprising an apparatus for estimating a media data stream as claimed in claim 5.

**8.** The receiver as claimed in claim 7, further comprising a space-time decoder for decoding the stream of receive symbols.

**9.** A method of estimating a media data stream of a radio transmission, comprising:

OFDM reception of a receive signal - superimposed in a shared frequency range - via a radio channel as the transmission channel;
performing DFT de-spreading via an inverse DFT on the receive signal so as to obtain a parallelized stream of symbols;
splitting up the parallelized stream of symbols into at least a first symbol substream and a second symbol substream;
associating a first substream of information symbols of the media data stream with the first symbol substream on the basis of a first symbol alphabet; and
associating a second substream of information symbols of the media data stream with the second symbol substream on the basis of a second symbol alphabet,
wherein

the first symbol alphabet corresponds to an m.ary modulation alphabet and the second symbol alphabet corresponds to an n.ary modulation alphabet, wherein $m \leq n$ and m, n are natural numbers, and/or
redundancy is added to the first and/or the second substream(s) so that the added redundancy is different for the first and second substreams, and/or
the symbol substreams are weighted with different power factors and are thereby associated with different transmit powers,

wherein the assignment of radio resources is adapted to assign, via scheduling, radio resources in form of inputs of a DFT spreader in the transmitter to the first transmission symbols and to the second transmission symbols, to balance off variable data rates of the first substream and of the second substream,
the first substream allowing a media content to be represented in a basic quality, and the second substream along with the first substream allowing the media content to be represented in an improved quality,

**10.** A computer program comprising a program code for performing the method as claimed in claim 4 or 9, when the program code runs on a computer or a processor.

## Revendications

**1.** Emetteur avec un dispositif pour l'attribution de symboles de transmission à un flux de données multimédia de symboles d'information, dans lequel le flux de données multimédia comporte un premier flux partiel pour la représentation d'un contenu multimédia en une qualité de base et un deuxième flux partiel avec des données additionnelles pour la représentation du contenu multimédia ensemble avec le premier flux partiel en une qualité améliorée, aux caractéristiques suivantes:

un premier moyen ($512_1$) destiné à attribuer des premiers symboles de transmission aux symboles d'information du premier flux partiel;
un deuxième moyen ($512_2$) destiné à attribuer

des deuxièmes symboles de transmission aux symboles d'informations du deuxième flux partiel,

dans lequel les premiers symboles de transmission peuvent être transmis par rapport aux deuxièmes symboles de transmission par l'intermédiaire d'un canal de transmission à moindre probabilité d'erreur, en ce que

les premiers symboles de transmission proviennent d'un alphabet de modulation m-aire et les deuxièmes symboles de transmission proviennent d'un alphabet de modulation n-aire, où m < n et m et n sont des nombres naturels,

l'émetteur présente par ailleurs un codeur de canal (1004) qui est réalisé pour ajouter de la redondance au premier et/ou au deuxième flux partiel, de sorte que la redondance ajoutée pour le premier et le deuxième flux partiel soit différente, et/ou

l'émetteur présente par ailleurs une commande de puissance (1008) qui est réalisée pour associer aux symboles de transmission du premier et du deuxième flux partiel différentes puissances de transmission en pondérant ces derniers par des facteurs de puissance différents;

un moyen d'étalement de transformée de Fourier discrète, DFT, (1012) qui est réalisé pour transformer les symboles de transmission du premier et du deuxième flux partiel par des séquences d'étalement de DFT d'une DFT en un domaine de fréquence et ensuite les additionner pour obtenir un signal de sortie; et

un émetteur de multiplexage par répartition orthogonale de la fréquence, OFDM, (520) qui est réalisé pour transmettre le signal de sortie - superposé dans une plage de fréquences commune - par l'intermédiaire d'un canal radioélectrique comme canal de transmission;

un moyen destiné à attribuer des ressources radioélectriques qui sont adaptées pour attribuer par planification des ressources radioélectriques sous forme d'entrées de la DFT aux premiers symboles de transmission et aux deuxièmes symboles de transmission pour compenser des débits de données variables du premier flux partiel et du deuxième flux partiel,

dans lequel l'émetteur est réalisé pour transmettre les premiers et les deuxièmes symboles de transmission comme transmission de radiodiffusion.

2. Emetteur selon la revendication 1, présentant par ailleurs un codeur espace-temps (1014) pour coder les symboles de transmission dans le domaine espace-temps.

3. Emetteur selon la revendication 1 ou 2, dans lequel l'émetteur OFDM (520) est réalisé pour transmettre par un nombre de transmetteurs qui diffère d'une dimension du dispositif d'étalement de DFT.

4. Procédé d'attribution de ressources radioélectriques à des symboles de transmission et de symboles de transmission à un flux de données multimédia de symboles d'information, dans lequel les données multimédia comportent un premier flux partiel pour la représentation d'un contenu multimédia en une qualité de base et un deuxième flux partiel avec des données additionnelles pour la représentation du contenu multimédia ensemble avec le premier flux partiel en un qualité améliorée, aux étapes suivantes consistant à:

attribuer des premiers symboles de transmission aux symboles d'information du premier flux partiel;

attribuer des deuxièmes symboles de transmission aux symboles d'information du deuxième flux partiel, où les premiers symboles de transmission peuvent être transmis par rapport aux deuxièmes symboles de transmission par l'intermédiaire d'un canal de transmission à moindre probabilité d'erreur, en ce que

les premiers symboles de transmission proviennent d'un alphabet de modulation m-aire et les deuxièmes symboles de transmission proviennent d'un alphabet de modulation n-aire, où m < n et m et n sont des nombres naturels,

au premier et/ou au deuxième flux partiel est ajoutée de la redondance, de sorte que la redondance ajoutée pour le premier et le deuxième flux partiel soit différente, et/ou

aux symboles de transmission du premier et du deuxième flux partiel est associée une puissance de transmission différente par pondération par différents facteurs de puissance;

transformer les symboles de transmission du premier et du deuxième flux partiel par des séquences d'étalement de DFT d'une DFT dans un domaine de la fréquence et ajouter ces derniers dans le domaine de la fréquence, pour obtenir un signal de sortie;

transmettre en multiplexage par répartition orthogonale de la fréquence, OFDM, (520), où le signal de sortie - superposé dans une plage de fréquences commune - est transmis par l'intermédiaire d'un canal radioélectrique comme canal de transmission; et

attribuer, par planification, des ressources radioélectriques sous forme d'entrées de la DFT aux premiers symboles de transmission et aux deuxièmes symboles de transmission, pour compenser les débits de données variables du premier flux partiel et du deuxième flux partiel;
transmettre les premiers et les deuxièmes symboles de transmission comme transmission de radiodiffusion.

**5.** Appareil d'estimation d'un flux de données multimédia d'une transmission de radiodiffusion, aux caractéristiques suivantes:

un récepteur OFDM (530) qui est réalisé pour recevoir un signal de réception - superposé dans une plage de fréquences commune - par l'intermédiaire d'un canal radioélectrique comme canal de transmission;
un bloc (540) destiné à effectuer un désétalement de DFT par une DFT inverse sur le signal de réception, pour obtenir un flux parallélisé de symboles, et à diviser le flux parallélisé de symboles en au moins un premier flux de symboles partiel et un deuxième flux de symboles partiel;
un premier estimateur de symboles destiné à associer un premier flux partiel de symboles d'informations du flux de données multimédia au premier flux de symboles partiel sur base d'un premier alphabet de symboles; et
un deuxième estimateur de symboles destiné à associer un deuxième flux partiel de symboles d'informations du flux de données multimédia au deuxième flux de symboles partiel sur base d'un deuxième alphabet de symboles, où

le premier alphabet de symboles correspond à un alphabet de modulation m-aire et le deuxième alphabet de symboles correspond à un alphabet de modulation n-aire, où $m < n$, et m, n sont des nombres naturels, et/ou
au premier et/ou au deuxième flux partiel est ajoutée de la redondance, de sorte que la redondance ajoutée pour le premier et le deuxième flux partiel soit différente, et/ou
les flux de symboles partiels sont pondérés par des facteurs de puissances différents et sont, de ce fait, associés à des puissances de transmission différentes,

dans lequel l'attribution de ressources radioélectriques est adaptée pour attribuer, par planification, des ressources radioélectriques sous forme d'entrées d'un moyen d'étalement de DFT dans l'émetteur aux premiers symboles de transmission et aux deuxièmes symboles de transmission, pour compenser des débits de données variables du premier flux partiel et du deuxième flux partiel,
dans lequel le premier flux partiel permet une représentation d'un contenu multimédia en une qualité de base et le deuxième flux partiel permet, ensemble avec le premier flux partiel, une représentation du contenu multimédia en une qualité améliorée.

**6.** Dispositif ou émetteur selon l'une des revendications 1 à 3, dans lequel les données multimédia sont des données vidéo codées, et le premier flux partiel et le deuxième flux partiel correspondent à des couches différentes de données vidéo codées.

**7.** Récepteur avec un dispositif d'estimation d'un flux de données multimédia selon la revendication 5.

**8.** Récepteur selon la revendication 7, présentant par ailleurs un décodeur espace-temps destiné à décoder le flux de symboles de réception.

**9.** Procédé d'estimation d'un flux de données multimédia d'une transmission de radiodiffusion, aux étapes suivantes consistant à:

recevoir en OFDM un signal de réception - superposé dans une plage de fréquences commune - par l'intermédiaire d'un canal radioélectrique comme canal de transmission;
effectuer un désétalement de DFT par une DFT inverse sur le signal de réception, pour obtenir un flux parallélisé de symboles;
diviser le flux parallélisé de symboles en au moins un premier flux de symboles partiel et un deuxième flux de symboles partiel;
associer un premier flux partiel de symboles d'information du flux de données multimédia au premier flux de symboles partiel sur base d'un premier alphabet de symboles; et
associer un deuxième flux partiel de symboles d'information du flux de données multimédia au deuxième flux de symboles partiel sur base d'un deuxième alphabet de symboles, où

le premier alphabet de symboles correspond à un alphabet de modulation m-aire et le deuxième alphabet de symboles correspond à un alphabet de modulation n-aire, où $m < n$, et m, n sont des nombres naturels, et/ou
au premier et/ou au deuxième flux partiel est ajoutée de la redondance, de sorte que la redondance ajoutée pour le premier et le deuxième flux partiel soit différente, et/ou
les flux de symboles partiels sont pondérés par des facteurs de puissance différents et, de ce fait, attribués à des puissances de transmission différentes,

l'attribution de ressources radioélectriques est adaptée pour attribuer, par planification, des ressources radioélectrique sous forme d'entrées d'un moyen d'étalement de DFT dans l'émetteur aux premiers symboles de transmission et aux deuxièmes symboles de transmission pour compenser des débits de données variables du premier flux partiel et du deuxième flux partiel,
dans lequel le premier flux partiel permet une représentation d'un contenu multimédia en une qualité de base et le deuxième flux partiel ensemble avec le premier flux partiel permet une représentation du contenu multimédia en une qualité améliorée.

**10.** Programme d'ordinateur avec un code de programme pour la mise en oeuvre du procédé selon la revendication 4 ou 9 lorsque le code de programme est exécuté sur un ordinateur ou un processeur.

Schicht 1 - 160 kBit/s
Schicht 2 - 200 kBit/s
Schicht 3 - 200 kBit/s
120
große bessere Qualität
110
große bessere Qualität
100
Schicht 1,2,3 - 560 kBit/s
Schicht 1,2 - 360 kBit/s
Schicht 1 - 160 kBit/s

FIG 1

BS3
200
MS
BS1
BS2

FIG 2

BS1
T2
T1
-x*2
x1
h1
MS
300
Übertragungssymbole
x1
x2
Kanalschätzer
Kombination
Detektion
h2
x*1
x2
BS2

FIG 3

FIG 4
3x1 Raum - Zeit - Kodierung
Tx 1
Tx 2
Tx 3
x-position [m]
y-position [m]
-1500
-1000
-500
0
500
1000
1500
1
2
3
4
5
6
7
8
9
10
11
12
13
14
15
16
17
18
19
20
21

510
520
530
540
Schicht 1
Schicht S
Demux
511
Mod
512
IFFT
522
523
521
CP
LO
524
SFN
525
A/D
532
531
FFT
533
534
$H_n$
MMSE
541
$V_n^{(MMSE)}$
$\vec{y}_n$
$\hat{\vec{x}}_n$
$W^*_{n,m}$
542
543
$\frac{1}{N}\sum_{n=1}^{N}$
$\frac{1}{p_1}$
$\frac{1}{p_S}$
Demod / Demux
545
Schicht H
$x_m$
$W_{1,m}$
$W_{N_1,m}$
$W_{N-N_S,m}$
$W_{N,m}$
$p_1$
$p_S$
$d_1^1$
$d_1^{N_1}$
$d_S^1$
$d_1^{N_S}$

FIG 5

SC - FDM - Leistungsfähigkeit für 3 SVC Schichten : 1x1, N=256, L=3, DFT-MMSE
Layer 1 (BPSK)
Layer 2 (16QAM*1.25)
LAyer 3 (64QAM*0,66)
unkod. BER
$10^{0}$
$10^{-1}$
$10^{-2}$
$10^{-3}$
$10^{-4}$
0
5
10
15
20
25
30
35
40
45
50
SNR [dB]

FIG 6

SC - FDM PAPR für 3 SVC Schichten : 1x1, N=256, L=3, DFT-MMSE
3 - Schicht BEispiel
OFDM QPSK
Wskt. (PAPR >PAPR$_0$)
$10^0$
$10^{-1}$
$10^{-2}$
$10^{-3}$
$10^{-4}$
4
5
6
7
8
9
10
11
12
13
PAPR [dB]

FIG 7

x-position [m]
y-position [m]
-1500
-1000
-500
0
500
1000
1500
1
2
3
4
5
6
7
8
9
10
11
12
13
14
15
16
17
18
19
20
21

FIG 8

Abdeckung (%)
SISO
SISO SFN
MRC
MRC SFN
MIMO Mux
MIMO Mux SFN
Alamouti
Alamouti SFN
MacroSTC 3x1
MacroSTC 3x2
Schicht 3 - 200 kBit/s
Schicht 2 - 200 kBit/s
Schicht 1 - 160 kBit/s
MMSE,SCFDM,DFT-Spreizung
ZF,OFDM
Übertragungskonzept/Schicht

FIG 9

1002
H.264 / SVC
SVC Stream
Video
Rohdaten
1000
Video
1004
1006
1008
1010
1012
DFT
1014
1016
1018
1018
IFFT
IFFT
1020
1026
1028
MMSE
FFT
FFT
1024
1022
1030
DFT
1032
SCFDM
1034
1036
1038
1040
1042
H.264 / SVC

FIG 10

(1) $$\vec{x}_n = \frac{1}{\sqrt{N}} \sum_{m=1}^{N_{dft}} W_{n,m} \cdot \vec{d}_m$$

(1.1) $$W_{n,m} = \exp\left(-2\Pi j \frac{(n-1)(m-1)}{N}\right)$$

(2) $$\vec{y}_n = H_n \cdot \vec{x}_n + \vec{\upsilon}_n$$

(3) $$\hat{\vec{d}}_m = \frac{1}{\sqrt{N}} \sum_{n=1}^{N} W^*_{n,m} \left( \frac{n_{t,x}}{SNR} \cdot I_{ntx} + H_n^H H_n \right)^{-1} \cdot H_n \cdot \vec{y}_n$$

(4) $$\sum_{s=1}^{S} N_s \leq N$$

(5) $$E\left( \sum_{s=1}^{S} \frac{1}{N_s} \sum_{n=1}^{N_s} \sum_{t=1}^{n_{Tx}} x_{s,t,n} \cdot x^*_{s,t,n} \right) \leq P_{Tx}$$

(6) $$PAPR = \frac{maximale_Leistung}{mittlere_Leistung} = \frac{\max_k = 1 \ldots N \cdot T \; |x(k)|^2}{\frac{1}{N \cdot T} \sum_{k=1}^{N \cdot T} |x(k)|^2}$$

FIG 11

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 20060013168 A1
- EP 1928115 A1
- US 20070165705 A1


### In der Beschreibung aufgeführte Nicht-Patentliteratur


- FLO-Physical layer: An Overview. **DAS DOKUMENT.** IEEE TRANSACTIONS ON BROADCASTING. IEEE SERVICE CENTER, 01. Marz 2007, vol. 53, 145-160
- Real-Time Video Multicast in WiMAX Networks. IEEE CONFERENCE ON COMPUTER COMMUNICATIONS. IEEE, 13. April 2008, 1579-1587
- SC-FDMA Waveform Design, Performance, Power Dynamics and Evolution to MIMO. IEEE INTERNATIONAL CONFERENCE ON PORTABLE INFORMATION DEVICES. IEEE, 01. Mai 2007, 1-6
- **T. SCHIERL ; T. STOCKHAMMER ; T. WIEGAND.** Mobile video transmission using scalable video coding. *IEEE Trans. Circuits Syst. Video Technol.,* 2007, vol. 17 (9), 1204-1217
- **I.E. TELETAR.** Capacity of multi-antenna gaussian channels. *European Transactions on Telecommunication,* 1999, vol. 10 (6), 585-596
- **B. HASSIBI ; B.M. HOCHWALD.** High-rate codes that are linear in space and time. *IEEE Trans. Inf. Theory,* 2002, vol. 48 (7), 1804-1824
- **S. SHAMAI ; B. ZAIDEL.** Enhancing the cellular downlink capacity via co-processing at the transmitting end. *Proc. IEEE VTC '01 Spring,* 2001, vol. 3, 1745-1749
- **V. JUNGNICKEL ; S. JAECKEL ; L. THIELE ; U. KRÜGER ; A. BRYLKA ; C. HELMOLT.** Capacity measurements in a multicell MIMO system. *Proc. IEEE Globecom,* 2006, vol. 06
- **S. ALAMOUTI.** A simple transmit diversity technique for wireless communications. *IEEE J. Sel. Areas Commun,* 1998, vol. 16 (8), 1451-1458
- **I.E. TELATAR.** Capacity of multi-antenna gaussian channels. *European Transactions on Telecommunications,* 1999, vol. 10 (6t), 585-596
- **A. VAN ZELST.** Space division multiplexing algorithms. *Proc. IEEE MeleCon ,00,* 2000, vol. 3, 1218-1221
- **S. JAECKEL ; V. JUNGNICKEL.** On the optimality of frequency-domain equalization in DFT-spread MIMO-OFDM systems. *Proc. IEEE WCNC,* 2008, vol. 08
- **V. JUNGNICKEL ; T. HINDELNAG ; T. HAUSTEIN ; W. ZIRWAS.** SC-FDMA waveform design, performance, power dynamics and evolution to MIMO. *Proc. IEEE Portable,* 2007, vol. 07
- **S. H. HAN ; J.H. LEE.** An overview of peak-to-average power ratio reduction techniques for multicarrier transmission. *IEEE Wireless Commun,* 2005, vol. 12 (2), 56-65
- **S.H. HAN ; J.H. LEE.** An overview of peak-to-average power ration reduction techniques for multicarrier transmission. *IEEE Wireless Commun,* 2005, vol. 12 (2), 56-65
- **L. JIANG ; L. THIELE ; V. JUNGNICKEL.** On the modelling of polarized MIMO Channel. *Proc. European Wireless Conference,* 2007, vol. 07
- **L. THIELE ; M. SCHELLMANN ; W. ZIRWAS ; V. JUNGNICKEL.** Capacity scaling of multiuser MIMO with limited feedback in a multicell environment. *Proc. Asilomar,* 2007, vol. 07